(19) **Europäisches Patentamt**
**European Patent Office**
**Office européen des brevets**

(11) **EP 2 573 942 B1**

(12) **EUROPEAN PATENT SPECIFICATION**

(45) Date of publication and mention
of the grant of the patent:
**16.12.2015 Bulletin 2015/51**

(51) Int Cl.:
*H03M 7/30* (2006.01)          *G10L 19/02* (2013.01)
*G10L 19/038* (2013.01)        *H04N 19/94* (2014.01)
*H04N 19/126* (2014.01)

(21) Application number: **11803544.3**

(22) Date of filing: **04.07.2011**

(86) International application number:
**PCT/JP2011/065274**

(87) International publication number:
**WO 2012/005210 (12.01.2012 Gazette 2012/02)**

(54) **ENCODING METHOD, DECODING METHOD, DEVICE, PROGRAM, AND RECORDING MEDIUM**

KODIERVERFAHREN, DEKODIERVERFAHREN SOWIE VORRICHTUNG DAFÜR, PROGRAMM
DAFÜR UND AUFZEICHNUNGSMEDIUM

PROCÉDÉ DE CODAGE, PROCÉDÉ DE DÉCODAGE, DISPOSITIF, PROGRAMME ET SUPPORT
D'ENREGISTREMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **05.07.2010 JP 2010152951**

(43) Date of publication of application:
**27.03.2013 Bulletin 2013/13**

(73) Proprietor: **Nippon Telegraph And Telephone
Corporation
Tokyo 100-8116 (JP)**

(72) Inventors:
• **FUKUI, Masahiro
Musashino-shi
Tokyo 180-8585 (JP)**
• **SASAKI, Shigeaki
Musashino-shi
Tokyo 180-8585 (JP)**
• **HIWASAKI, Yusuke
Musashino-shi
Tokyo 180-8585 (JP)**
• **KOYAMA,Shoichi
Musashino-shi
Tokyo 180-8585 (JP)**
• **TSUTSUMI, Kimitaka
Musashino-shi
Tokyo 180-8585 (JP)**

(74) Representative: **MERH-IP Matias Erny Reichl
Hoffmann
Patentanwälte PartG mbB
Paul-Heyse-Strasse 29
80336 München (DE)**

(56) References cited:
**EP-A1- 2 101 318          EP-A1- 2 546 994
WO-A1-2009/093714      WO-A1-2009/093714
JP-A- 8 044 399          JP-A- 2011 009 860
JP-A- 2011 009 861       JP-A- 2011 009 868
JP-A- 2011 009 869       US-A1- 2008 312 759**

• **EDITOR G 722 1-FB: "Draft new ITU-T
Recommendation G.722.1-FB Low-complexity
full-band audio coding for high-quality
conversational applications (for Consent)", ITU-
T SG16 MEETING; 22-4-2008 - 2-5-2008;
GENEVA,, no. T05-SG16-080422-TD-WP3-0340,
29 April 2008 (2008-04-29), XP030100515,**
• **YAN MING CHENG ET AL: "SPEECH
ENHANCEMENT BASED CONCEPTUALLY ON
AUDITORY EVIDENCE", IEEE TRANSACTIONS
ON SIGNAL PROCESSING, IEEE SERVICE
CENTER, NEW YORK, NY, US, vol. 39, no. 9, 1
September 1991 (1991-09-01), pages 1943-1954,
XP000262929, ISSN: 1053-587X, DOI:
10.1109/78.134427**

## Description

TECHNICAL FIELD

The present invention relates to a technology for encoding or decoding signal sequences of acoustic signals, video signals, and other signals, such as voice and music, by vector quantization.

BACKGROUND ART

In an encoding device described in Patent literature 1, an input signal is first normalized by division by a normalization value. The normalization value is quantized to generate a quantization index. The normalized input signal is vector-quantized to generate the index of a representative quantization vector. The generated indexes, which are the quantization index and the index of the representative quantization vector, are output to a decoding device.

The decoding device decodes the quantization index to generate a normalization value. The decoding device also decodes the index of the representative quantization vector to generate a decoded signal. The normalized decoded signal is multiplied by the normalization value to generate a decoded signal.

For the vector quantization, for example, a vector quantization method such as algebraic vector quantization (AVQ) described in Non-patent literature 1 is applied to normalized values of a predetermined number of samples. In this vector quantization method, a representative quantization vector is obtained by giving pulses within a range of a quantization bit number set in advance. That is, in this vector quantization method, bits representing the sample values are assigned to and non-zero quantized values are obtained for only some of the predetermined number of samples, while such bits are not assigned to and zero quantized values are obtained for the remaining samples.

Non patent literature 2 describes the G722.1FB codec, a low complexity full bandwidth codec for conversational speech and audio coding. The coding algorithm is based on transform coding with adaptive time resolution, adaptive bit-allocation and low complexity lattice vector quantization.

[PRIOR ART LITERATURE]

[PATENT LITERATURE]

Patent literature 1: Japanese Patent Application Laid Open No. H7-261800

NON-PATENT LITERATURE

Non-Patent literature 1: Recommendation ITU-T G 718, SERIES G: TRANSMISSION SYSTEMS AND MEDIA, DIGITAL SYSTEMS AND NETWORKS, Digital terminal equipments - Coding of voice and audio signals, Frame error robust narrow-band and wideband embedded variable bit-rate coding of speech and audio from 8-32 Kbit/s
Non Patent literature 2: Draft new ITU-T Recommendation G722.1-FB, Low-complexity full-band audio coding for high-quality conversational applications, 29 April 2008

SUMMARY OF THE INVENTION

PROBLEMS TO BE SOLVED BY THE INVENTION

In an encoding device using the above vector quantization, and the corresponding decoding device, when a predetermined number of quantization bits is less than the number of bits needed for the quantization, the frequency in which a frequency component that is included in the input signal is not found in a decoded signal (the decoded signal lack the frequency components) is increased. A frequency component that is included in the input signal but not found in the decoded signal is referred to as a spectrum hole. The occurrence of the spectrum hole increases the frequency in which the presence or absence of the frequency component in the decoded signal varies discontinuously over time. Humans are sensitive to those temporally discontinuous variations in the presence or absence. When the input signal is an acoustic signal, for example, these variations may be perceived as noise known as musical noise. In addition, when the input signal is video signal, a problem of block noise, which corresponds to musical noise in an acoustic signal, unfavorably occurs.

The number of bits needed for the quantization varies according to the type of the input signal. According to the type of the input signal, even if the above encoding and decoding devices are used, the musical noise and the block noise (hereinafter, the musical noise and the block noise will be collectively referred to as "musical noise and the like") may not cause significant problems, or the above encoding and decoding devices may be preferable to improve the encoding accuracy.

That is, the suitable encoding and decoding methods vary according to the type of the input signal. Such a problem may occur not only when the input signal is frequency-domain signal but also when the input signal is time-domain signal.

In view of such problems, the present invention provide a technology that reduces the musical noise and the like appropriately in accordance with the type of the input signal when a sufficient code bit length is not secured and all samples having large values in the input signal are not quantized by a vector quantization method such as AVQ.

MEANS TO SOLVE THE PROBLEMS

The present invention proposes an encoding method, a decoding method, an encoding device, a decoding device, a program and a computer-readable medium having the features of the respective independent claims. Preferred embodiments are described in the dependent claims.

According to an aspect, for encoding, when an evaluation value is a second reference value or less, a second encoding mode is selected, where the evaluation value corresponds to the number of samples which correspond to values less than a first reference value among a predetermined number of input samples. In the second encoding mode, a normalization value that is a representative value of the predetermined number of samples is quantized to obtain a quantized normalization value and a normalization-value quantization index corresponding to the quantized normalization value; when a difference value that is obtained by subtracting a value corresponding to the quantized normalization value from a value corresponding to the magnitude of each sample is positive and the sample is positive, the difference value is set as a quantization candidate corresponding to the sample; when the difference value is positive and the sample is negative, the sign (the positive or negative sign) of the difference value is reversed and the result is set as the quantization candidate corresponding to the sample; and a plurality of quantization candidates are jointly vector-quantized to obtain a vector quantization index. When the second encoding mode is not selected, a first encoding mode other than the second encoding mode is selected. Mode information representing the selected encoding mode is generated, and the predetermined number of samples are encoded by the first encoding mode or the second encoding mode that is selected.

For decoding, when input mode information has a second value, a second decoding mode is selected. In the second decoding mode, a decoded normalization value corresponding to an input normalization-value quantization index is obtained; a plurality of values corresponding to an input vector quantization index are obtained as decoded values; when the decoded value is zero, a value having a magnitude corresponding to a recalculated normalization value that takes on a value that decreases with increasing sum of the absolute values of a predetermined number of decoded values is obtained as a decoded signal; when the decoded value is positive, the linear sum of the decoded value and the decoded normalization value is obtained as a decoded signal; and when the decoded value is negative, the sign of the linear sum of the absolute value of the decoded value and the decoded normalization value is reversed and the result is set as a decoded signal. When the mode information has a first value, a first decoding mode other than the second decoding mode is selected. The decoding process is performed by the first decoding mode or the second decoding mode that is selected.

EFFECTS OF THE INVENTION

When many samples having large values are encoded, spectrum holes may occur, whereby the possibility of the occurrence of the musical noise and the like can be increased. In the encoding process of the present invention, the possibility of the occurrence of the musical noise and the like is estimated by the magnitude of the evaluation value. When the possibility is high, an encoding mode that quantizes actively dominant samples including samples that are not quantized by a vector quantization method such as AVQ is selected, and mode information representing the selected encoding mode is generated. Accordingly, even if a code bit length is insufficient and all large samples of the input signal cannot be quantized by a vector quantization method such as AVQ, the occurrence of the musical noise and the like can be appropriately reduced in accordance with the type of the input signal. In the decoding process of the present invention, since the decoding mode according to the mode information is used, even if the code bit length is insufficient and all large samples of the input signal cannot be quantized by the AVQ method or the like, the musical noise and the like can be appropriately reduced in accordance with the type of the input signals.

BRIEF DESCRIPTION OF THE DRAWINGS

Fig. 1 is a functional block diagram of examples of an encoding device and a decoding device.
Fig. 2 is a functional block diagram of an example of a second encoder.
Fig. 3 is a functional block diagram of a second decoder.

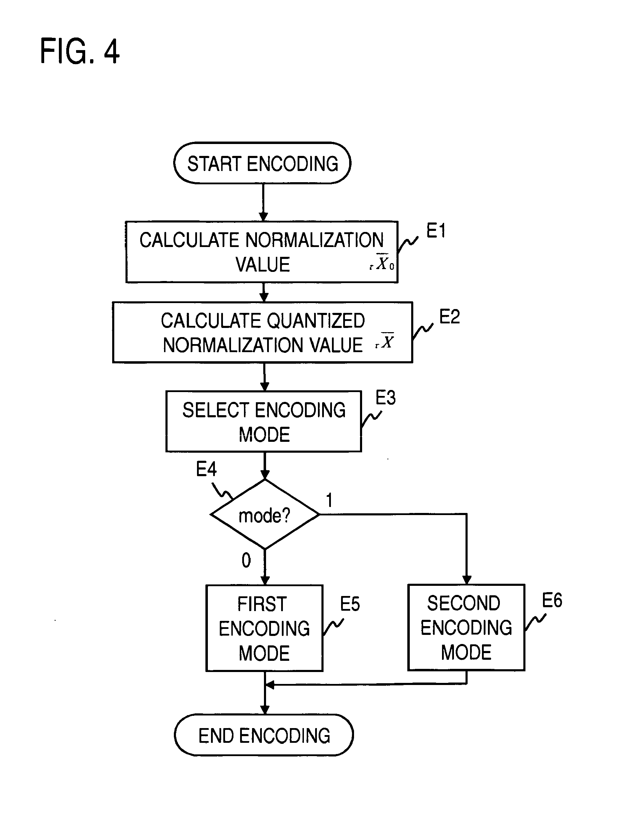

Fig. 4 is a flowchart of an example of an encoding method.
Fig. 5 is a flowchart of an example of Step E3.
Fig. 6 is a flowchart of an example of Step E3.
Fig. 7 is a flowchart of an example of Step E3.
Fig. 8 is a flowchart of an example of Step E3.
Fig. 9 is a flowchart of an example of Step E3.
Fig. 10 is a flowchart of an example of Step E3.
Fig. 11 is a flowchart of an example of Step E6.
Fig. 12 is a flowchart of an example of Step E62.
Fig. 13 is a flowchart of an example of Step E65.
Fig. 14 is a flowchart of an example of a decoding method.
Fig. 15 is a flowchart of an example of Step D4.
Fig. 16 is a flowchart of an example of Step D43.
Fig. 17 is a flowchart of examples of Steps D44 and D44'.
Fig. 18 is a flowchart of examples of Steps D44 and D44'.
Fig. 19 is a flowchart of an example of Step D44'.
Fig. 20 is a flowchart of examples of Steps D43, D44, and D44'.
Fig. 21 is a flowchart of examples of Steps D43, D44, and D44'.

DETAILED DESCRIPTION OF THE EMBODIMENTS

Hereinafter, embodiments of the present invention will be described in detail.

<Principle>

In an encoding process, it is determined whether or not a predetermined number of samples, which are included in the input signal, are sparse. If the samples are determined to be not sparse, the samples are encoded by an encoding mode that includes a process for reducing the musical noise and the like. On the other hand, if the samples are determined to be sparse, the samples are encoded by an encoding mode that does not include a process for reducing the musical noise and the like, for example. In a decoding process, mode information specifying an encoding mode is input, a decoding mode is specified by the mode information, and the code is decoded by the specified decoding mode. Here, "a predetermined number of samples are sparse" means that most of the samples have small amplitudes, e.g., only some of samples have large amplitude and the other many samples have amplitude of almost zero.

When the predetermined number of samples are not sparse, the number of bits needed for the sample quantization tends to be large. This often increases the frequency in which the predetermined number of quantization bits are less than bits needed for the quantization, resulting in remarkable problem of the musical noise and the like. Accordingly, when the samples are not sparse, the encoding and decoding modes capable of reducing the musical noise and the like should be used.

On the other hand, when the predetermined number of samples are sparse, the number of bits needed for the quantization of the samples tends to be small. This often decreases the frequency in which the predetermined number of quantization bits are less than bits needed for the quantization, and the problem of the musical noise and the like is not so significant. Accordingly, when the samples are sparse, the need for reducing the musical noise and the like is low, and the input signal may be encoded by an encoding mode that does not have process to reduce the musical noise and the like.

This will be described in an Example. First, encoding modes and decoding modes, which are selected based on whether or not the samples are sparse, will be presented as an example. Hereinafter, an encoding mode and a decoding mode that are selected when the samples are sparse will be referred to a first encoding mode and a first decoding mode, respectively, and they are collectively referred to as a first mode; and an encoding mode and a decoding mode that are selected when the samples are not sparse will be referred to a second encoding mode and a second decoding mode, respectively, and they are collectively referred to as a second mode. The mode information s corresponding to the first mode is "0", and mode information s corresponding to the second mode is "1".

<First Mode (s = 0)>

An example of the first mode is a vector quantization mode such as AVQ disclosed in Non-Patent literature 1, which gives pulses, within a range of a quantization bit number set in advance, to a sample sequence obtained by normalizing a predetermined number of samples by a quantized normalization value.

In the illustrated first encoding mode, a normalization value that is representative of the predetermined number of input samples is calculated. The normalization value is quantized to obtain a quantized normalization value and a normalization-value quantization index corresponding to the quantized normalization value. The sample sequence that is obtained by dividing (normalizing) the predetermined number of input samples by the quantized normalization value is vector-quantized by a vector quantization mode in which non-zero quantized values are obtained only for some of the predetermined number of samples and zero quantized values are obtained for the remaining samples, whereby a vector quantization index is obtained.

A sample sequence having high correlation with the sample sequence of the input predetermined number of samples may be selected, from a plurality of sample sequences in which non-zero quantized values are given only to some of the predetermined number of samples and zero quantized values are given to the remaining samples, to obtain the index of the representative quantization vector; and a normalization-value quantization index representing a quantized normalization value may be obtained, which minimizes the error between the input predetermined number of samples and the sample sequence obtained by multiplying the representative quantization vector by the quantized normalization value.

In the illustrated first decoding mode, the normalization-value quantization index is decoded to generate a normalization value. In addition, the vector quantization index is decoded to generate a sample sequence. A decoded signal sample sequence is obtained by multiplying the samples of the generated sample sequence by the normalization value.

<Example 1 of Second Mode (s = 1)>

In Example 1 of the second encoding mode, a normalization value that is representative of a predetermined number of input samples is calculated. The normalization value is quantized to obtain a quantized normalization value and a normalization-value quantization index corresponding to the quantized normalization value. When a difference value that is obtained by subtracting a value corresponding to the quantized normalization value from a value corresponding to the magnitude of the value of each sample is positive and the value of the sample is positive, the difference value is set as the quantization candidate corresponding to the sample. When the difference value is positive and the value of the sample is negative, the sign of the difference value is reversed and the result is set as the quantization candidate corresponding to the sample. When the difference value is not positive, zero is set as the quantization candidate corresponding to the sample. A plurality of quantization candidates are jointly vector-quantized to obtain a vector quantization index. For the vector quantization, for example, a vector quantization method such as algebraic vector quantization (AVQ) described in Non-patent literature 1 is applied to the predetermined number of quantization candidates. In this vector quantization method, the representative quantization vector is obtained by giving pulses within a range of a quantization bit number set in advance. That is, in this vector quantization method, bits for representing the sample values are assigned to and non-zero quantized values are obtained for only some of the predetermined number of quantization candidates, while such bits are not assigned to and zero quantized values are obtained for the remaining quantization candidates. In the AVQ method, any quantization value corresponding to a quantization candidate of zero is zero.

In Example 1 of the second decoding mode, a decoded normalization value corresponding to an input normalization-value quantization index is obtained. A plurality of values corresponding to an input vector quantization index are obtained as a plurality of decoded values. Calculation is performed to obtain a recalculated normalization value that decreases with increasing sum of the absolute values of a predetermined number of decoded values. When a decoded value is positive, the linear sum of the decoded value and the decoded normalization value is obtained as a decoded signal. When a decoded value is negative, the sign of the linear sum of the decoded value and the decoded normalization value is reversed and the result is obtained as a decoded signal. When a decoded value is zero, a decoded signal sample sequence is obtained, which is a sequence of decoded signal samples each having value (value having the magnitude corresponding to the recalculated normalization value) obtained by randomly inverting the sign of the product of the recalculated normalization value and a first constant.

In Example 1 of the second encoding mode, by selecting some dominant components including samples that are not quantized by the AVQ method or the like from all frequency components and by actively quantizing them, occurrence of spectral holes related to the dominant components can be prevented and the musical noise can be reduced.

In Example 1 of the second decoding mode, by assigning a non-zero value based on the recalculated normalization value when the decoded value is zero, a spectral hole which can occur if, for example, an input signal is a frequency-domain signal can be prevented and the musical noise can be reduced.

<Example 2 of Second Mode (s = 1)>

The following second mode may be used.

In Example 2 of the second encoding mode, a normalization value that is representative of a predetermined number of input samples is calculated. The normalization value is quantized to obtain a quantized normalization value, and a normalization-value quantization index corresponding to the quantized normalization value is obtained. When a difference value that is obtained by subtracting a value corresponding to the quantized normalization value from a value corresponding to the magnitude of the value of each sample is positive and the value of the sample is positive, the difference value is set as the quantization candidate corresponding to the sample. When the difference value is positive and the value of the sample is negative, the sign of the difference value is reversed and the result is set as the quantization candidate corresponding to the sample. A plurality of quantization candidates are jointly vector-quantized to obtain a vector quantization index. In addition, within a range of the number of bits not actually used for codes corresponding to the vector quantization index among bits assigned for codes corresponding to a vector quantization index, sign information representing sign of the sample for which the difference value are not positive is output. The vector quantization method is the same as that of Example 1 of the second method. When the difference value is not positive, zero is set as the quantization candidate corresponding to sample.

In Example 2 of the second decoding mode, a decoded normalization value corresponding to an input normalization-value quantization index is obtained. A plurality of values corresponding to an input vector quantization index are obtained as a plurality of decoded values. Calculation is performed to obtain a recalculated normalization value that decreases with increasing sum of the absolute values of a predetermined number of decoded values. For each of the decoded values, when the decoded value is positive, the linear sum of the decoded value and the decoded normalization value is obtained as a decoded signal; and when the decoded value is negative, the sign of the linear sum of the decoded value and the decoded normalization value is reversed and the result is obtained as a decoded signal. When the decoded value is zero and the sign information corresponding to the decoded value is input, a value (value having the magnitude corresponding to the recalculated normalization value) obtained by giving the sign represented by the sign information to a product of the recalculated normalization value and a first constant is obtained as a decoded signal. When the decoded value is zero and the sign information corresponding to the decoded value is not input, a decoded signal sample sequence is obtained, which is a sequence of decoded signal samples each having value (value having the magnitude corresponding to the recalculated normalization value) obtained by randomly inverting the sign of the product of the recalculated normalization value and a first constant.

Also in Example 2 of the second encoding mode, occurrence of a spectrum hole can be prevented and a musical noise and the like can be reduced. In addition, in Example 2 of the second encoding mode, since the sign information can be transmitted using an unused bit region, the quality of a decoded signal can be improved.

In addition, in Example 2 of the second decoding mode, a spectrum hole can be eliminated, and the musical noise and the like can be reduced. Furthermore, in Example 2 of the second decoding mode, by using the input sign information, the quality of a decoded signal can be improved.

<Relation between Property of Sample and Optimal Mode>

While the first mode does not have a countermeasure for reducing the musical noise and the like, the second mode has a countermeasure for reducing the musical noise and the like.

However, when a predetermined number of input samples are sparse, the musical noise and the like hardly cause significant problems. In the second mode, since a value other than zero is appropriately assigned using the recalculated normalization value when a decoded value is zero, the accuracy of encoding is lower than that of the first mode when a predetermined number of input samples are sparse.

As above, since each mode has strong points and weak points, different modes should be used depending on whether or not a predetermined number of input samples are sparse. More specifically, when a predetermined number of input samples are sparse (for example, a Glockenspiel's frequency-domain signal), the musical noise and the like hardly cause significant problems, and accordingly the encoding accuracy can be higher by using the first mode rather than the second mode. On the other hand, when a predetermined number of input samples are not sparse (for example, a voice, musical sounds of multiple sources, environmental noise, or the like), the second mode should be used instead of the first mode because the musical noise and the like cause problems.

As described above, by selecting the different modes depending on the property of the input samples, even if a code bit length is insufficient and all large value samples in the input signal cannot be quantized by a vector quantization method such as AVQ, the musical noise and the like can be reduced appropriately in accordance with the type of the input signal.

<Configuration>

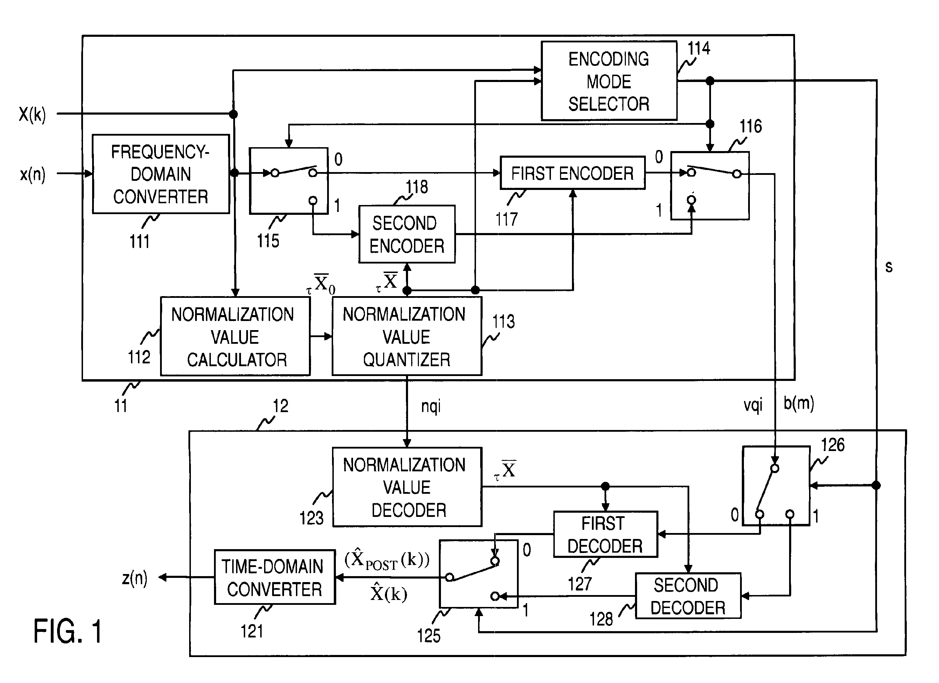

As illustrated in Fig. 1, an encoding device 11 of an embodiment, includes a normalization value calculator 112, a normalization value quantizer 113, an encoding mode selector 114, switching units 115 and 116, a first encoder 117, and a second encoder 118, for example. As illustrated in Fig. 1, a decoding device 12 of an embodiment, includes a normalization value decoder 123, switching units 125 and 126, a first decoder 127, and a second decoder 128, for example. The encoding device 11 may include a frequency-domain converter 111, for example. The decoding device 12 may include a time-domain converter 121, for example.

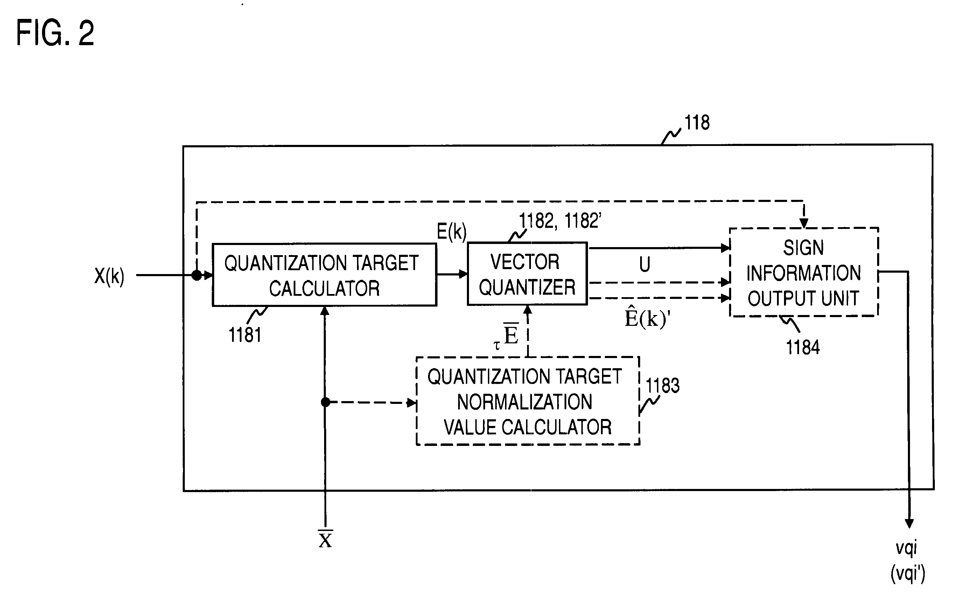

The first encoder 117 is a processing unit for encoding by a first encoding mode (for example, the above first mode). The second encoder 118 includes a quantization-candidate calculator 1181 and a vector quantizer 1182, as illustrated in Fig. 2. The second encoder 118 may include a quantization-candidate normalization value calculator 1183 and a sign information output unit 1184. The second encoder 118 may include a vector quantizer 1182' instead of the vector quantizer 1182.

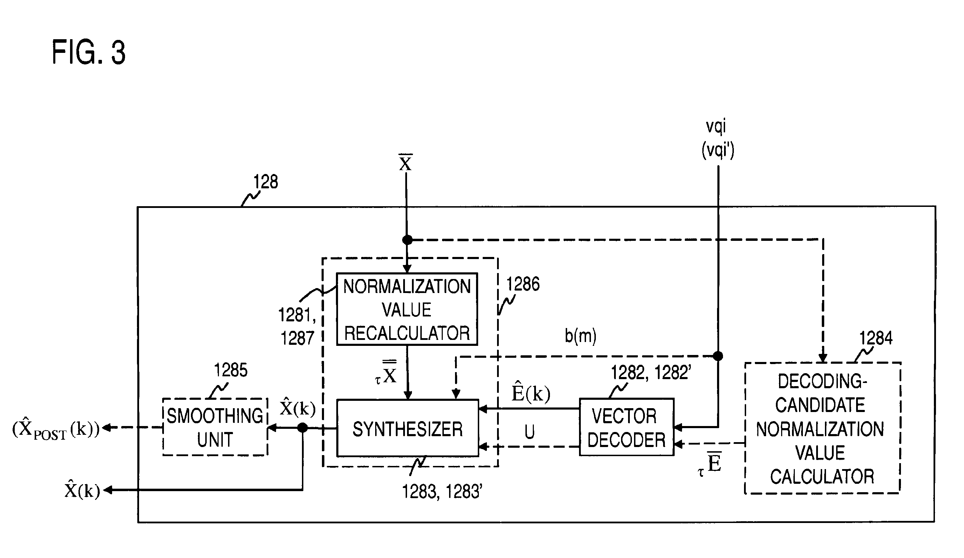

A first decoder 127 is a processing unit for decoding by a first decoding mode (for example, the above first mode). The second decoder 128 includes a normalization value recalculator 1281, a vector decoder 1282, and a synthesizer 1283, for example, as illustrated in Fig. 3. The second decoder 128 may include a decoding-candidate normalization value calculator 1284 and a smoothing unit 1285. The second decoder 128 may include a normalization value recalculator 1287 instead of the normalization value recalculator 1281, may include a vector decoder 1282' instead of the vector decoder 1282, and may include a synthesizer 1283' instead of the synthesizer 1283. Furthermore, the second decoder 128 may include a synthesizer 1286 instead of the synthesizers 1283 and 1283' and the normalization value recalculators 1281 and 1287.

<Encoding Process>

The encoding device 11 executes steps in an encoding method illustrated in Fig. 2.

An input signal X(k) is input to the normalization value calculator 112, the encoding mode selector 114, and the switching unit 115. The input signal X(k) in this example is a frequency-domain signal obtained by transforming, into a frequency domain, a time-domain signal x(n) that is a time series signal such as a voice signal, an acoustic signal, or an image signal. The frequency-domain input signal X(k) may be directly input to the encoding device 11, or the frequency-domain converter 111 may transform an input time-domain signal x(n) into the frequency domain to generate the frequency-domain input signal X(k). When the frequency-domain converter 111 generates the frequency-domain input signal X(k), the frequency-domain converter 111 transforms the input time-domain signal x(n) into a frequency-domain input signal X(k) according to a modified discrete cosine transform (MDCT), for example, and outputs the frequency-domain input signal X(k). Here, n is a number (discrete time number) of a signal in the time domain, and k is a number (discrete frequency number) of a signal (sample) in the frequency domain. A larger value of k corresponds to a higher frequency. Assuming that one frame is constituted by L samples, a time-domain signal x(n) is transformed into a frequency domain for each frame, and an input signal X(k) in the frequency domain (k = 0, 1, ..., L-1) constituting L frequency components is generated. L is a predetermined positive number, for example, 64 or 80.

The normalization value calculator 112 calculates a normalization value $_\tau \bar{X}_0$ for each frame, where the normalization value $_\tau \bar{X}_0$ is a representative value of a predetermined number $C_0$ of samples among the L samples of the input signal X(k) (Step E1). Here, $\bar{X}_0$ is the character $X_0$ with an overline. Here, $C_0$ is L or a common divisor of L other than one and L. If $C_0$ is L, it means that a normalization value is calculated per each L samples. If $C_0$ is a common divisor of L, it means that L frequency components are divided into sub-bands and a normalization value is calculated per each sub-band. For example, if L = 64 and one sub-band is composed of eight frequency components, eight sub-bands are formed and a normalization value is calculated per each sub-band. In addition, when $C_0$ is L, $\tau$ is zero and the normalization value $_\tau \bar{X}_0$ is a representative value of L samples. That is, when $C_0$ is L, one normalization value $_\tau \bar{X}_0$ is calculated for each frame. On the other hand, when $C_0$ is a common divisor of L other than one and L, $\tau$ is an integer ($\tau = 0, ..., (L / C_0) - 1$) corresponding to each sub-band of one frame, and the normalization value $_\tau \bar{X}_0$ is a value representative of the $C_0$ samples that belong to each sub-band corresponding to $\tau$. That is, when $C_0$ is a common divisor of L other than one and L, (L / $C_0$) normalization values $_\tau \bar{X}_0$ ($\tau = 0, ..., (L / C_0) -1$) are calculated for each frame. In addition, k = $\tau \cdot C_0, \cdots, (\tau + 1) \cdot C_0 - 1$ regardless of the value of $C_0$. $_\tau \bar{X}_0$ calculated by the normalization value calculator 112 is sent to the normalization value quantizer 113.

[Example of Normalization value $_\tau \bar{X}_0$]

The normalization value $_\tau \bar{X}_0$ is a representative value of $C_0$ samples. In other words, the normalization value $_\tau \bar{X}_0$ is a value that corresponds to $C_0$ samples. An example of the normalization value $_\tau \bar{X}_0$ is the following square root to a power average value of the $C_0$ samples.

$$\tau\overline{X}_0 = \sqrt{\frac{\sum_{k=\tau\cdot C_0}^{(\tau+1)\cdot C_0-1} X(k)^2}{C_0}}$$

Another example of the normalization value $\tau X_0^-$ is the following value, which is obtained by dividing, by $C_0$, the square root to a total power value of the $C_0$ samples.

$$\tau\overline{X}_0 = \frac{\sqrt{\sum_{k=\tau\cdot C_0}^{(\tau+1)\cdot C_0-1} X(k)^2}}{C_0}$$

Still another example of the normalization value $\tau X_0^-$ is the following average amplitude value of the $C_0$ samples.

$$\tau\overline{X}_0 = \frac{\sum_{k=\tau\cdot C_0}^{(\tau+1)\cdot C_0-1} |X(k)|}{C_0}$$

Any other normalization value $\tau X_0^-$ may be used (the end of the description of [Example of Normalization value $\tau X_0^-$])

The normalization value quantizer 113 quantizes the normalization value $\tau X_0^-$ to obtain a quantized normalization value $\tau X^-$ and obtains a normalization-value quantization index (nqi) corresponding to the quantized normalization value $\tau X^-$ (Step E2). Here, $\tau X^-$ is the character $\tau X$ with an overline The quantized normalization value $\tau X^-$ is sent to the encoding mode selector 114, the first encoder 117, and the second encoder 118, and a code (bit stream) corresponding to the normalization-value quantization index is sent to the decoding device 12.

The encoding mode selector 114 determines whether or not a predetermined number of samples of the input signal are sparse, outputs first mode information (s = 0) that represents the first encoding mode when the samples are sparse, and outputs second mode information (s = 1) that represents the second encoding mode when the samples are not sparse. In this embodiment, based on the number of samples having magnitudes smaller than a threshold or the number of samples having magnitudes being a threshold or less, the encoding mode selector 114 selects an encoding mode that corresponds to the predetermined number of normalized input signal samples and outputs mode information s specifying the selected encoding mode (Step E3).

[Example 1 of Step E3]

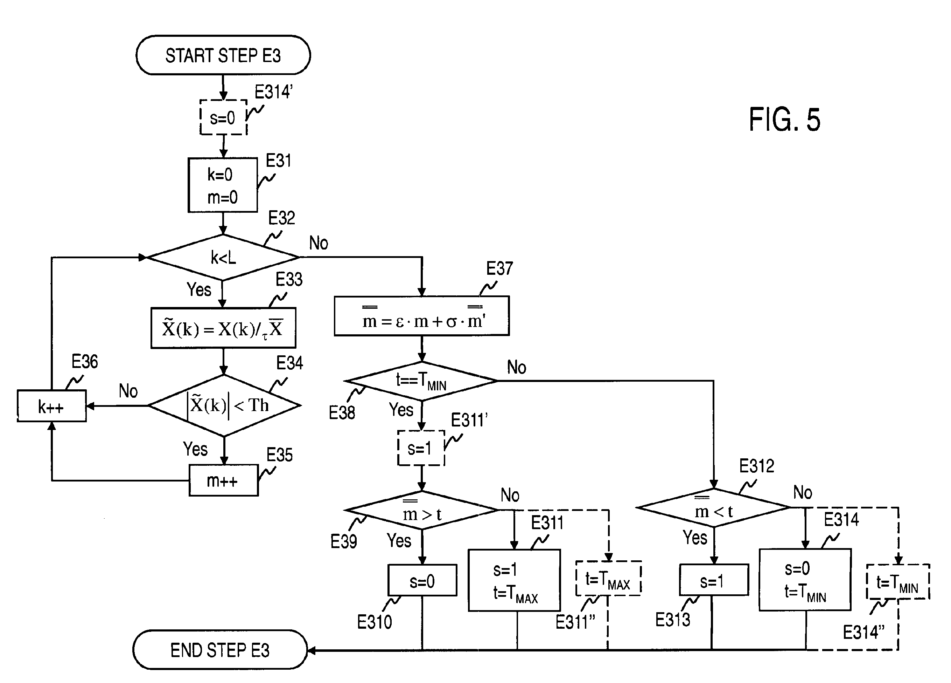

In Example 1 of Step E3, an encoding mode is selected for each frame by performing a process illustrated in Fig. 5 for each frame.

The encoding mode selector 114 initializes k and m as k = 0 and m = 0 (Step E31).

The encoding mode selector 114 compares k with L (Step E32); and the process proceeds to Step E33 ifk is less than L or, the process proceeds to Step E37 if k is not less than L. Here, a method for "comparing $\delta$ with $\eta$" is not limited, and any comparison method may be used as along as it can determine the magnitude relation between $\delta$ and $\eta$. For example, a process of comparing $\delta$ with $\eta$ for checking whether or not $\delta < \eta$ may be a process of determining whether or not $\delta < \eta$, a process of determining whether or not $0 < \eta - \delta$, a process of determining whether or not $\delta \geq \eta$, or a process of determining whether or not $0 \geq \eta - \delta$.

In Step E33, the encoding mode selector 114 normalizes $X(k)$ using $\tau X^-$ to generate a normalized value $\tilde{X}(k)$ (Step E33). Here, $X^\sim$ represents the character X with an overtilde. For example, the encoding mode selector 114 normalizes $X(k)$ by division by $\tau X^-$ to generate a normalized value $\tilde{X}(k)$, as the following equation. $\tilde{X}(k) = X(k)/\tau\overline{X}$

The encoding mode selector 114 calculates the absolute value $|\tilde{X}(k)|$ (the magnitude of a value corresponding to the sample) of X˜(k), and compares |X˜(k)| with a predetermined threshold Th (first reference value) (Step E34). If |X˜(k)| is less than Th, the encoding mode selector 114 increments m by one (updates the value of m by setting m + 1 as a new value of m) (Step E35), increments k by one (Step E36), and proceeds to Step E32. If |X˜(k)| is not less than Th, the encoding mode selector 114 increments k by one without incrementing m (Step E36) and proceeds to Step E32. Here, the threshold Th is a positive constant and may be 0.5, for example.

If it is it is determined in Step E32 that k is not less than L, the encoding mode selector 114 obtains a smoothed count value $m^=$ (evaluation value), which is a weighted addition value of a count value m and a count value $m^=$, calculated in the previous time (an evaluation value calculated in the previous time) (Step E37). Here, $m^=$ represents the character m with a double overline. For example, the encoding mode selector 114 obtains the smoothed count value $m^=$ according to the following equation. Here, ε and σ are adjustment constants, which are determined in accordance with required performance and the specifications. For example, ε and σ are positive constants that satisfy a relation of "ε + σ =1". For example, ε = 0.3, and σ = 0.7.

$$\overline{\overline{m}} = \varepsilon \cdot m + \sigma \cdot \overline{\overline{m}}'$$

The smoothing reduces the frequency in which different determination is made between frames as to whether or not samples are sparse. This reduces the frequency in which the encoding modes are different according to the frames, and suppresses a musical noise and the like which are occurred by the change of the encoding mode. Here, the count value $m^=$, calculated in the previous time is a pre-smoothed or smoothed count value which is calculated in the immediately previous frame by the encoding mode selector 114. When the smoothed count value $m^=$, calculated in the previous time is zero, the encoding mode selector 114 may set $m^= = m$ without smoothing the count value m. Furthermore, the encoding mode selector 114 may set $m^= = m$ without smoothing the count value m regardless of whether or not the smoothed count value $m^=$, is zero.

The encoding mode selector 114 determines whether or not a second reference value t is a threshold $T_{MIN}$ (Step E38); if t is $T_{MIN}$, the encoding mode selector 114 compares $m^=$ with t (Step E39); and $m^=$ is more than t, the encoding mode selector 114 sets s to zero, outputs the mode information s = 0 (Step E310), and exits the process of Step E3. Here, $T_{MIN}$ is a predetermined positive constant. The initial value of t may be $T_{MIN}$, for example. Here, a method for "determining whether or not δ is zero" is not limited, and any determination that corresponds to whether or not δ is zero may be made. For example, whether or not δ is zero may be determined by determining whether or not δ = 0, whether or not δ is zero may be determined by determining whether or not δ = γ (γ ≠ 0), or whether or not δ is zero may be determined by determining whether or not δ >0 and δ <0. If $m^=$ is not more than t in Step E39, the encoding mode selector 114 sets s to one, and t to $T_{MAX}$, outputs mode information s = 1 (Step E311), and exits the process of Step E3. Here, $T_{MAX}$ is a threshold, which is a predetermined positive constant larger than $T_{MIN}$.

If it is determined in Step E38 that t is not $T_{MIN}$, the encode mode selector 114 compares $m^=$ with t (Step E312); and if $m^=$ is less than t, then the encode mode selector 114 sets s to one, outputs mode information s = 1 (Step E313), and exits the process of Step E3. If $m^=$ is not less than t, then the encode mode selector 114 sets s to zero, and t to $T_{MIN}$, outputs mode information s= 0 (Step E314), and exits the process of Step E3. The process of Step E38 and subsequent steps reduces the frequency in which different determination is made between the immediately previous frame and the current frame as to whether or not samples are sparse (whether s =0 or 1). As a result, this reduces the frequency in which the encoding modes are different according to the frames, and suppresses a musical noise and the like which are occurred by the change of the encoding mode. In other words, by the process of Step E38 and subsequent steps, the second reference value t when a previous predetermined number of samples are encoded by the first encoding mode (s = 0) is smaller than when the previous predetermined number of samples are encoded by the second encoding mode (s = 1). This reduces the frequency in which the encoding modes are different between the previous time and the current time, and suppresses a musical noise and the like which are occurred by the change of the encoding mode. When $C_0 = L$, the "previous predetermined number of samples" are samples belonging to the immediately previous frame. When $C_0$ is a common divisor of L other than one and L, the "previous predetermined number of samples" may be samples belonging to same sub-band in the immediately previous frame, or samples belonging to the previous or following sub-band in the current frame.

[Example 2 of Step E3]

In Example 2 of Step E3, as illustrated in Fig. 5, first, s is set to zero (Step E314'), and subsequent Steps E31 to E38 thereof are the same as those of Step E3 of Example 1.

If t is $T_{MIN}$ in Step E38, the encoding mode selector 114 updates the mode information s to one (Step E311'), and compares $m^=$ with t (Step E39); and if $m^=$ is more than t, then the encoding mode selector 114 sets s to zero, outputs the mode information s = 0 (Step E310), and exits the process of Step E3. If $m^=$ is not more than t, the encoding mode selector 114 sets t to $T_{MAX}$, outputs the mode information s = 1 (Step E311 "), and exits the process of Step E3.

If it is determined in Step E38 that t is not $T_{MIN}$, the encoding mode selector 114 compares $m^=$ with t (Step E312); and if $m^=$ is less than t, then the encoding mode selector 114 sets s to one, outputs the mode information s = 1 (Step E313), and exits the process of Step E3. If $m^=$ is not less than t , the encoding mode selector 114 sets t to $T_{MIN}$, outputs the mode information s = 0 (Step E314"), and exits the process of Step E3.

[Example 3 of Step E3]

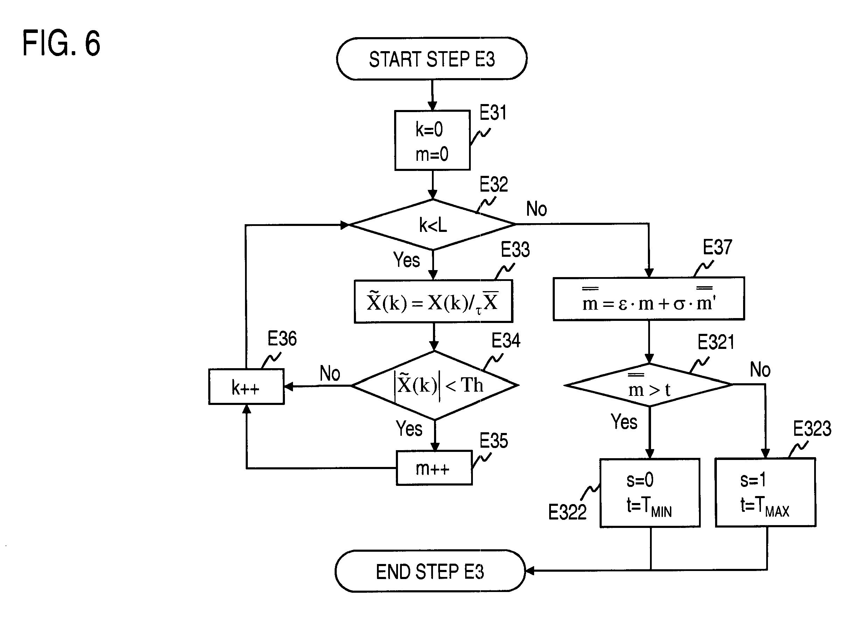

In Example 3 of Step E3, as illustrated in Fig. 6, the process of Steps E31 to E37 is performed, which is same as that of Example 1 of Step E3. As described in Example 1 of Step E3, $m^=$ may be set to m without performing the process of Step E37.

Next, the encoding mode selector 114 compares $m^=$ with t (Step E321); and if $m^=$ is more than t, then the encoding mode selector 114 sets s to zero, and t to $T_{MIN}$, outputs the mode information s = 0 (Step E322), and exits the process of Step E3. If $m^=$ is not more than t, the encoding mode selector 114 sets s to one, and t to $T_{MAX}$, outputs the mode information s = 1 (Step E323), and exits the process of Step E3.

The process of Step E321 and subsequent steps reduces the frequency in which different determination is made between the immediately previous frame and the current frame as to whether or not samples are sparse (whether s =0 or 1). This reduces the frequency in which the encoding modes are different between the frames, and suppresses a musical noise and the like which are occurred by the change of the encoding mode.

[Example 4 of Step E3]

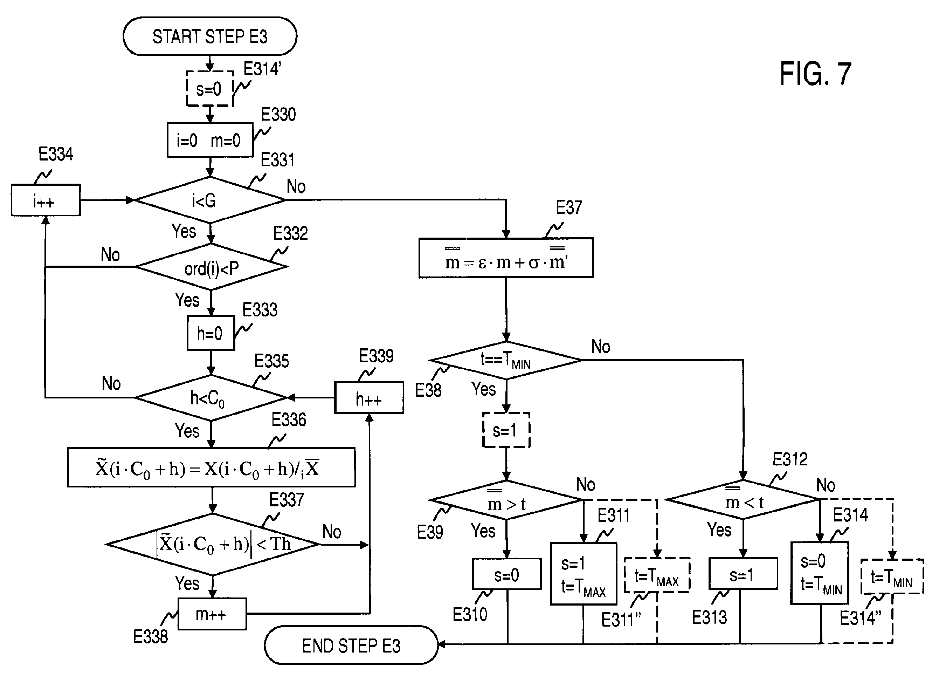

In Example 4 of Step E3, an encoding mode is selected for each frame by performing the process illustrated in Fig. 7 for each frame.

The encoding mode selector 114 initializes i and m as i = 0 and m = 0 (Step E330).

The encoding mode selector 114 compares i with G ($G = L/C_0$) (Step E331), and proceeds to Step E332 if i is less than G, and proceeds to Step E37 if i is not less than G When $C_0$ represents the number of samples of a sub-band, G represents a total number of sub-bands included in one frame. When $C_0$ represents the number L of samples included in one frame, G = 1. This Example is significant when $C_0$ represents the number of samples of a sub-band.

In Step E332, the encoding mode selector 114 compares ord (i) with an perceptual importance threshold P (a reference based on auditory perceptual characteristics) (Step E332); and if ord(i) is not less than P, the encoding mode selector 114 increments i by one (Step E334), and proceeds to Step E331. If ord(i) is less than P, the encoding mode selector 114 initializes h to zero (Step E333), and proceeds to Step E335.

When $C_0$ represents the number of samples of a sub-band, ord(i) is a function that receives an index i = 0, ..., $(L/C_0)$-1 and outputs a priority level of a sub-band corresponding to the index i, where the index i is an integer greater than or equal to zero corresponding to each sub-band included in one frame. The priority level is an integer between 0 and $(L/C_0)$ - 1 both inclusive; the smaller value means the higher priority level. For example, when a total number $L/C_0$ of sub-bands included in one frame is eight, and the priority levels of sub-bands corresponding to the indices i = 0, 1, 2, 3, 4, 5, 6, and 7 are 2, 1, 0, 3, 5, 4, 6, and 7, ord(0) = 2, ord(1) = 1, ord(2) = 0, ord(3) = 3, ord(4) = 5, ord(5) = 4, ord(6) = 6, and ord(7) = 7. The priority levels of sub-bands included in a single frame may be dynamically determined in accordance with the input signal X(k) or may be fixedly determined. When the priority levels are dynamically determined, the higher priority level is assigned to the sub-band corresponding to the larger quantized normalization value $_\tau X^-$, for example. When the priority levels are fixedly determined, the priority level of each sub-band is determined in consideration of human auditory perceptual characteristics, for example (the higher priority levels are assigned to the sub-bands corresponding lower frequencies, for example.) When $C_0$ represents the number of samples L included in one frame, ord(i) = 0. The perceptual importance threshold P is an integer constant that is one or more and $L/C_0$ or less, and Example 3 of Step E3 is significant when $1 < P < L/C_0$. For example, when $L/C_0$ is eight, P may be four.

In Step E335, the encoding mode selector 114 compares h with $C_0$ (Step E335); and if h is not less than $C_0$, the encoding mode selector 114 increments i by one (Step E334) and proceeds to Step E331. If h is less than $C_0$, the encoding mode selector 114 normalizes $X(i \cdot C_0 + h)$ using $_i X^-$ to generate a normalized value $X^\sim(i \cdot C_0 + h)$ (Step E336). For example, the encoding mode selector 114 divides $X(i \cdot C_0 + h)$ by $_i X^-$ to obtain the normalized value $X^\sim(i \cdot C_0 + h)$ as shown in the following equation.

$$\widetilde{X}(i \cdot C_0 + h) = X(i \cdot C_0 + h)/_i\overline{X}$$

The encoding mode selector 114 calculates the absolute value $|\tilde{X}(i \cdot C_0+h)|$ of $\tilde{X}(i \cdot C_0+h)$ and compares $|\tilde{X}(i \cdot C_0+h)|$ with a predetermined threshold Th (Step E337); and if $|\tilde{X}(i \cdot C_0+h)|$ is less than Th, the encoding mode selector 114 increments m by one (Step E338), increments h by one (Step E339), and proceeds to Step E335. If $|\tilde{X}(i \cdot C_0+h)|$ is not less than Th, the encoding mode selector 114 increments h by one without incrementing m (Step E339), and proceeds to Step E335.

The process of Step E37 and subsequent steps are the same as that of Example 1 of Step E3. Here, the smoothed count value $m^=$ of this example is a value corresponding to the number of samples which includes samples satisfying the criterion based on the auditory perceptual characteristics and which correspond to values less than the first reference value among the predetermined number of samples.

Alternatively, first, s maybe set to zero as shown in Example 2 of Step E3 (Step E314'), and then the process of Step E37 and subsequently steps maybe performed as shown in Example 2 of Step E3.

[Example 5 of Step E3]

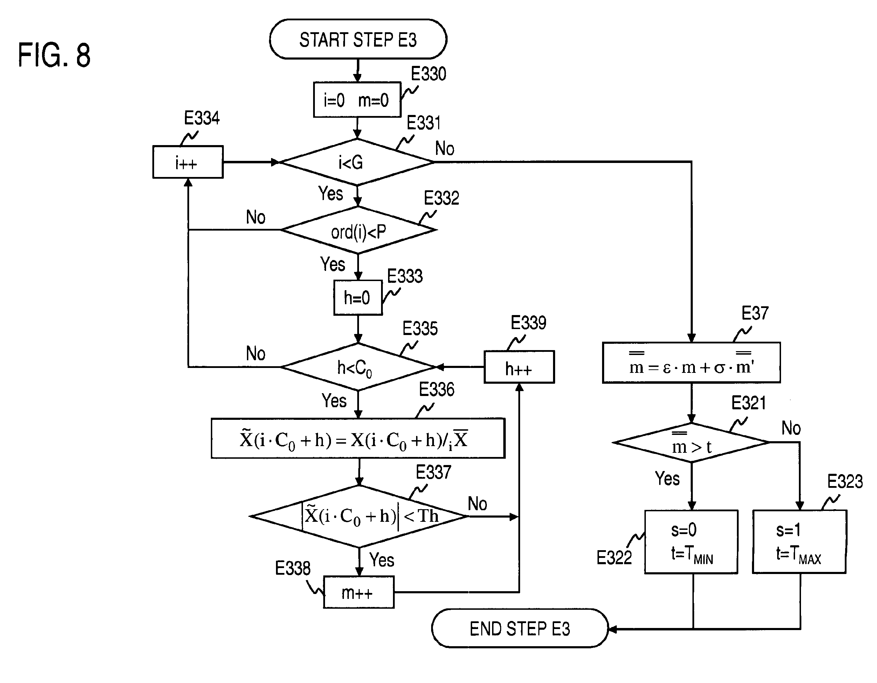

In Example 5 of Step E3, as illustrated in Fig. 8, the process of Steps E330 to E37 is performed, which are the same as those of Example 4 of Step E3. Next, the process of Steps E321 to E323 is performed, which are the same as those of Example 3 of Step E3. As described in Example 1 of Step E3, $m^=$ may be set to m without performing the process of Step E37.

[Example 6 of Step E3]

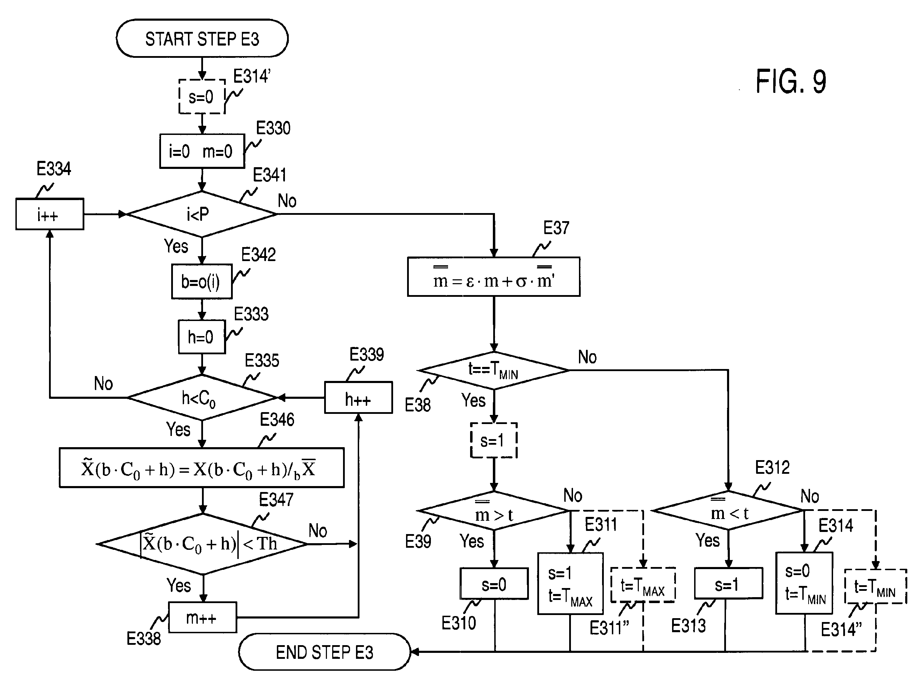

In Example 6 of Step E3, the encoding mode is selected for each frame by performing the process illustrated in Fig. 9 for each frame.

The encoding mode selector 114 initializes i and m as i = 0 and m = 0 (Step E330).

The encoding mode selector 114 compares i with the perceptual importance threshold P (Step E341), proceeds to Step E342 if i is less than P, and proceeds to Step E37 if i is not less than P.

In Step E342, the encoding mode selector 114 sets b = o(i) (Step E342). Here, o(i) represents an i-th (here, i = 0, ..., $(L/C_0)-1$) element (index) of a set SET in which integer indices that are zero or more identifying sub-bands included in one frame are arranged in the order of descending priorities. For example, if a total number $L/C_0$ of sub-bands included in one frame is eight, the sub-bands are identified as 0, ..., 7, and the set SET = {1, 0, 3, 2, 5, 4, 6, 7}, then o(i) represents an i-th element of the set SET = {1, 0, 3, 2, 5, 4, 6, 7} from the beginning. Here, the leading element is represented as a 0-th element. In this example, the priority level of a sub-band identified by "1" is the highest, and the priority level of a sub-band identified by "7" is the lowest. The priority levels of sub-band included in one frame may be dynamically determined in accordance with an input signal X(k) or may be fixedly determined. When the priority levels are dynamically determined, the higher priority level is assigned to the sub-band corresponding to the larger quantized normalization value $_\tau X^-$, for example. When the priority levels are fixedly determined, the priority level of each sub-band is determined in consideration of human auditory perceptual characteristics, for example (the higher priority level is assigned to the sub-band corresponding lower frequency, for example.) When $C_0$ represents the number of samples L included in one frame, ord(i) = 0. This Example is significant when $C_0$ represents the number of samples of the sub-band.

The encoding mode selector 114 initializes h to zero (Step E333), and proceeds to Step E335.

In Step E335, the encoding mode selector 114 compares h with $C_0$ (Step E335); and if h is not less than $C_0$, the encoding mode selector 114 increments i by one (Step E334), and proceeds to Step E341. If h is less than $C_0$, the encoding mode selector 114 generates a normalized value $\tilde{X}(b \cdot C_0+h)$ by normalizes $X(b \cdot C_0+h)$ using $_b X^-$ (Step E346). For example, the encoding mode selector 114 divides $X(b \cdot C_0+h)$ by $_b X^-$ to obtain the normalized value $\tilde{X}(b \cdot C_0+h)$ as shown in the following equation.

$$\widetilde{X}(b \cdot C_0 + h) = X(b \cdot C_0 + h)/_b\overline{X}$$

The encoding mode selector 114 calculates the absolute value $|\tilde{X}(b \cdot C_0+h)|$ of $\tilde{X}(b-C_0+h)$ and compares $|\tilde{X}(b \cdot C_0+h)|$ with a predetermined threshold Th (Step E347); and if $|\tilde{X}(b \cdot C_0+h)|$ is less than Th, the encoding mode selector 114 increments m by one (Step E338), increments h by one (Step E339), and proceeds to Step E335. If $|\tilde{X}(b \cdot C_0+h)|$ is not less than Th, the encoding mode selector 114 increments h by one without incrementing m (Step E339), and proceeds to Step E335.

The process of Step E37 and subsequent steps are the same as that of Example 1 of Step E3.

Alternatively, first, s is set to zero as show in Example 2 of Step E3 (Step E314'), and then the process of Step E37 and subsequently steps is performed as shown in Example 2 of Step E3.

[Example 7 of step E3]

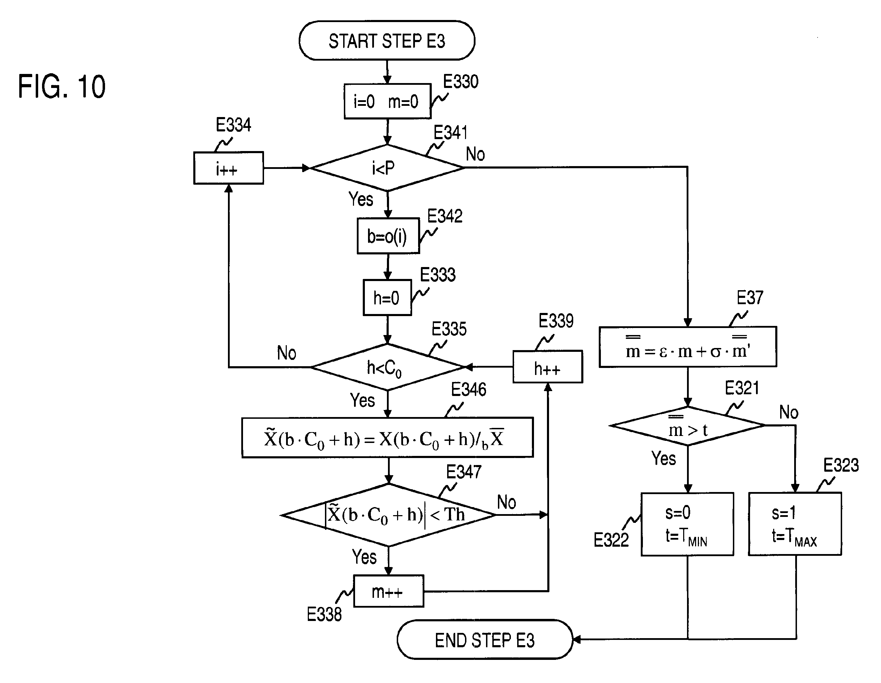

In Example 7 of Step E3, as illustrated in Fig. 10, the process of Steps E330 to E37 is performed, which are the same as those of Example 6 of Step E3. Next, the process of Steps E321 to E323 is performed, which are the same as those of Example 3 of Step E3. As described in Example 1 of Step E3, $m^=$ may be set to m without performing the process of Step E37.

[Example 8 of Step E3]

As a modification of Examples 1 to 3 of Step E3, instead of Step E32 illustrated in Figs. 5 and 6, the encoding mode selector 114 may compare k with Q; and the encoding mode selector 114 may proceed to Step E33 ifk is less than Q, and proceed to Step E37 if k is not less than Q. Here, Q is a constant in the range of $0 < Q < L$. Accordingly, the determination can be performed in consideration of human auditory perceptual characteristics since the determination of Step E34 is performed only on samples corresponding to low frequencies, to which humans are perceptive.

[Example 9 of Step E3]

As a modification of Examples 4 and 5 of Step E3, a function that receives i = 0, ..., $(L/C_0)-1$ and outputs an arbitrary integer between zero and $(L/C_0)$ -1 both inclusive may be used instead of ord(i). In addition, in the Examples of Step E3, ord(i) may be replaced with o(i) or, o(i) may be replaced with ord(i).

[Example 10 of Step E3]

In addition, a method of determining whether or not the evaluation value is the second reference value or less is not limited to that described above, where the evaluation value corresponds to the number of samples which are included in the predetermined number of input samples and which values less than the first reference value correspond to. For example, as a modification of Examples 1 to 9 of Step E3, the first reference value may be $Th+\theta$ or $Th-\theta$, the second reference value may be $t+\Delta$ or $t-\Delta$ (here, $\theta$ and $\Delta$ are positive constants), or the same determination may be performed using "$\leq$" instead of "<" or using "$\geq$" instead of ">". Alternatively, a substantially same determination may be performed by counting the number of samples to which values larger than a third reference value correspond and comparing the count value with a fourth reference value (the end of the description of [Example of Step E3]).

The mode information s that is output from the encoding mode selector 114 is sent to the switching units 115 and 116, and a code (bit stream) that corresponds to the mode information s is sent to the decoding device 12.

When s is zero (when the samples are sparse), the switching units 115 and 116 send the input signal X(k) to the first encoder 117 (Step E4). The first encoder 117 receives X(k) and $_\tau X^-$ as inputs, encodes X(k) by using the first encoding mode such as the described first mode set in advance, and outputs a code (bit stream) that includes the vector quantization index (vqi) and the like (Step E5). This code is sent to the decoding device 12.

When s is one (when the samples are not sparse), the switching units 115 and 116 send the input signal X(k) to the second encoder 118 (Step E4). The second encoder 118 receives X(k) and $_\tau X^-$ as inputs, encodes X(k) by using the second encoding mode set in advance, and outputs a code (bit stream) that includes the vector quantization index and the like (Step E6). This code is sent to the decoding device 12.

[Example 1 of Step E6]

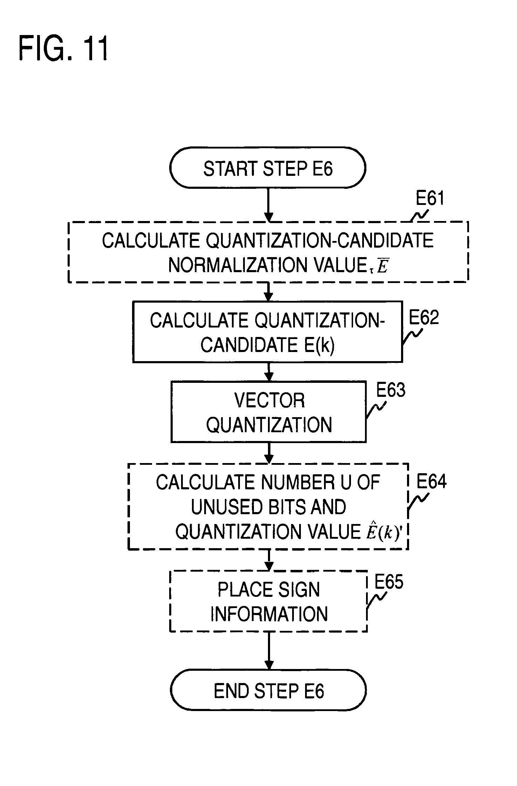

The second encoder 118 receives X(k) and $_\tau X^-$ as inputs and encodes the input signal X(k) by performing a process illustrated in Fig. 11, for example.

The quantization-candidate calculator 1181 of the second encoder 118 (Fig. 2) calculates a difference value E(k)' by subtracting a value corresponding to the quantized normalization value from a value corresponding to the magnitude of the value X(k) of each sample of the input signal; when the difference value E(k)' is positive and the value X(k) of the sample is positive, the difference value E(k)' is set as a quantization candidate E(k) corresponding to the sample; when the difference value E(k)' is positive and the value X(k) of the sample is negative, the sign of the difference value E(k)' is reversed and the result is set as the quantization candidate E(k) corresponding to the sample; and when the difference value E(k)' is not positive, zero is set as the quantization candidate E(k) corresponding to the sample. Examples of the value corresponding to the magnitude of the value X(k) of each sample include: an absolute value of the value X(k) of each sample; a value proportional to an absolute value of the value X(k) of each sample; a value obtained by multiplying an absolute value of the value X(k) of each sample by a constant or a variable $\theta$; and an absolute value of a value obtained by multiplying the value X(k) of each sample by a constant and/or a variable. Examples of the value corresponding to the quantized normalization value include: the quantized normalization value; a value proportional to the quantized normalization value; and a value obtained by multiplying the quantized normalization value by a constant and/or a variable (Step E62). The quantization candidate E(k) is sent to the vector quantizer 1182.

[Example 1 of Step E62]

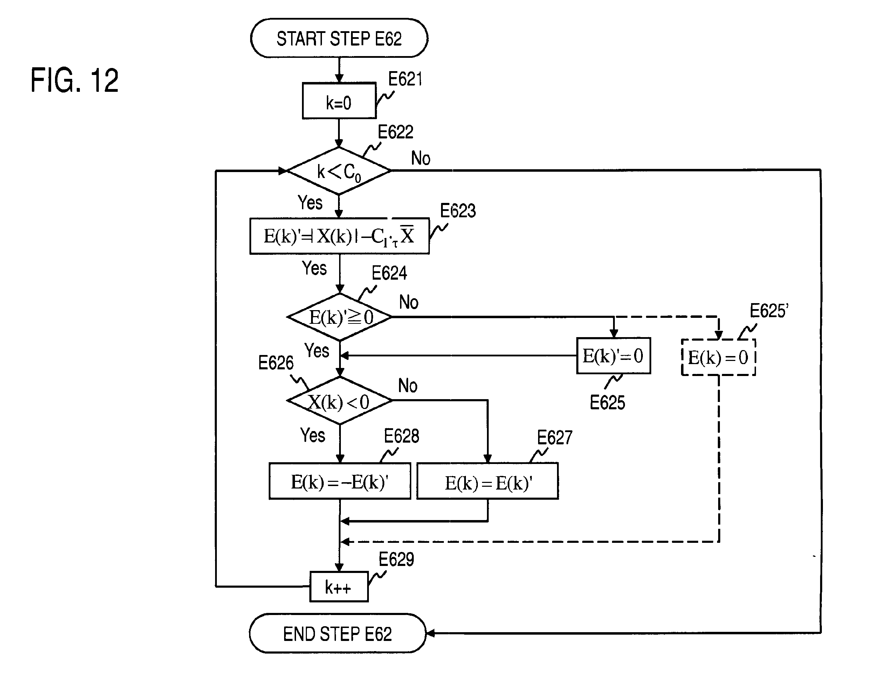

For example, the quantization-candidate calculator 1181 determines a quantization candidate E(k) corresponding to the value X(k) of each sample of the input signal by performing process described in Fig. 12.

The quantization-candidate calculator 1181 initializes k to zero (Step E621).

The quantization-candidate calculator 1181 compares k with $C_0$ (Step E622) and exits the process of Step E62 if k is not less than $C_0$. If k is less than $C_0$, the quantization-candidate calculator 1181 calculates a difference value E(k)' that is obtained from the absolute value of the value X(k) of each sample of the input signal and the quantized normalization value (Step E623). For example, the quantization-candidate calculator 1181 calculates a value of E(k)' defined by the following Equation (1). Here, $C_1$ is an adjustment constant of the normalization value, and may be 1.0, for example.

$$E(k)' = |X(k)| - C_{1 \cdot \tau}\overline{X} \qquad (1)$$

The quantization-candidate calculator 1181 compares the difference value E(k)' with zero (Step E624); the quantization-candidate calculator 1181 updates E(k)' with zero (Step E625) and proceeds to Step E626 ifE(k)' is not equal to or more than zero; and proceeds to Step E626 without updating E(k)' if E(k)' is equal to or more than zero.

In Step E626, the quantization-candidate calculator 1181 compares X(k) with zero (Step E626); the quantization-candidate calculator 1181 sets the difference value E(k)' to the quantization candidate E(k) if X(k) is not less than zero (Step E627); and sets -E(k)', which is obtained by reversing the sign of the difference value E(k)', to the quantization candidate E(k) if X(k) is less than zero (Step E628).

The quantization-candidate calculator 1181 increments k by one (updates the value ofk by setting k+1 as a new value ofk) and proceeds to Step E622 (Step E629).

[Example 2 of Step E62]

The quantization-candidate calculator 1181, for example, may determine a quantization candidate E(k) corresponding to the value X(k) of each sample of the input signal as below.

The quantization-candidate calculator 1181 performs the process of Steps E621 to E624 as illustrated in Fig. 12.

If it is determined in Step E624 that the difference value E(k)' is not equal to or more than zero, the quantization-candidate calculator 1181 sets E(k) to zero (Step E625'), increments k by one (Step E629), and proceeds to Step E622. If it is determined in Step E624 that the difference value E(k)' is equal to or more than zero, the quantization-candidate calculator 1181 performs the process of Step E626 and subsequent steps of Example 1 of Step E62.

[Example 3 of Step E62]

Instead of branching of the process based on whether or not E(k)' is equal to or more than zero in Step E624 of Examples 1 and 2 of Step E62, the process may be branched in Step E624 based on whether or not E(k)' > 0 (the end of the description of [Example of Step E62]).

The vector quantizer 1182 jointly vector-quantizes a plurality of quantization candidates E (k) corresponding to a plurality of samples to obtain a vector quantization index (step E63).

The vector quantization index represents a representative quantization vector. For example, the vector quantizer 1182 selects a representative quantization vector closest to a vector composed of a plurality of quantization candidates E (k) corresponding to a plurality of samples from among a plurality of representative quantization vectors stored in a vector codebook storage not shown in the figure. And the vector quantizer 1182 outputs a vector quantization index representing the selected representative quantization vector to accomplish vector quantization. The vector quantizer 1182 jointly vector-quantizes the quantization candidates E (k) corresponding to $C_0$ samples, for example. The vector quantizer 1182 performs the vector quantization by using a quantization method in which a quantized value $E^{\wedge}(k)'$ is always zero when the quantization candidate E(k) is zero, such as an algebraic vector quantization (AVQ) method (see G718). In this way, when the input signal is a frequency-domain signal, for example, by selecting some dominant components including samples that are not quantized by the AVQ method or the like from all frequency components and by actively quantizing them, occurrence of spectral holes related to the dominant components can be prevented and the musical noise can be reduced.

A code (bit stream) corresponding to the vector quantization index is sent to the decoding device 12 (the end of the description of [Example 1 of Step E6]).

[Example 2 of Step E6]

The bit number of the code obtained by the vector quantization varies depending on the input signal. For some input signals, the bit number of the code (the vector quantization index or the like) obtained by the vector quantization may be less than a bit number assigned for the vector quantization, and part of bits assigned for the vector quantization may remain unused. In Example 2 of Step E6, the remained bits area is used, and sign information corresponding to the quantization candidate $E(k)$ of zero is generated.

In Example 2 of Step E6, as illustrated in Fig. 11, the quantization-candidate calculator 1181 performs the process of Step E62, and the vector quantizer 1182' performs the process of Step E63. The vector quantizer 1182' calculates, as an number of unused bits, U, the bit number of bits that are not used in actual vector quantization, among the bits assigned for the vector quantization. Note that the "bits assigned for the vector quantization" mean bits assigned for a code (a code corresponding to the vector quantization index) obtained by the vector quantization, among codes sent from the encoding device 11 to the decoding device 12. The "bit number assigned for the vector quantization" means the bit number of the bits assigned for the vector quantization. The "bit number assigned for the vector quantization" may be determined for each frame, or may be determined for each sub-band. In addition, the "bit number assigned for the vector quantization" may vary depending on the input signal, or may be constant irrespective of the input signal.

In an example, the number of unused bits, U, is calculated in each frame (in each unit of L samples). For example, the vector quantizer 1182' obtains the number of unused bits, U, by subtracting, from the number of bits allocated for vector quantization in a target frame to be processed, the total number of bits of the vector quantization index obtained by vector quantization of L samples included actually in the frame.

Further, the vector quantizer 1182' outputs the plurality of quantized values $\hat{E}(k)'$, which are obtained by decoding the vector quantization index locally. For example, the vector quantizer 1182' outputs respective components of the representative quantization vector expressed by the vector quantization index, as the quantized values $\hat{E}(k)'$. The quantized value $\hat{E}(k)'$ in this example is equal to a decoded value $\hat{E}(k)$ obtained by the decoding device 12. Note that the quantized value $\hat{E}(k)'$ need not be identical with the decoded value $\hat{E}(k)$, and any quantized value $\hat{E}(k)'$ which is zero when the decoded value $\hat{E}(k)$ is zero and is not zero when the decoded value $\hat{E}(k)$ is not zero may be used. Note that $\hat{E}$ is the character E with a circumflex. The vector quantizer 1182' sends the vector quantization index, the number of unused bits, U, and the quantized value $\hat{E}(k)'$ to the sign information output unit 1184 (Step E64).

The sign information output unit 1184 writes the sign information of a sample that makes the quantization value $\hat{E}(k)$ zero, of the input signal $X(k)$ in the frequency domain, into a region of unused bits (referred to as "unused bit region") among the bits assigned for the vector quantization. In other words, the sign information output unit 1184 places the sign information that expresses the sign of the value $X(k)$ of each sample that does not make $E(k)'$ positive (makes $E(k)'$ equal to or less than zero), into the unused bit region of a code (bit stream) corresponding to the vector quantization index (Step E65). Note that the unused bit region can be identified by, for example, a reference position (for example, an initial address) of a given unused bit region and the input number of unused bits, U.

As a result, the unused bit region can be effectively utilized, and the quality of decoded signals can be enhanced. Note that the upper limit of the bit number of the sign information written into the unused bit region is the number of unused bits, U. Accordingly, all pieces of the sign information are not necessarily written into the unused bit region. Under the circumstances, it is preferable that the sign information output unit 1184 extract the sign information in accordance with criteria defined by considering human auditory perceptual characteristics and write the extracted sign information into the unused bit region. For example, the sign information output unit 1184 preferentially extracts the sign information of the input signal $X(k)$ in the frequency domain at frequencies easily perceived by human beings, and writes the extracted sign information into the unused bit region.

[Example of Step E65]

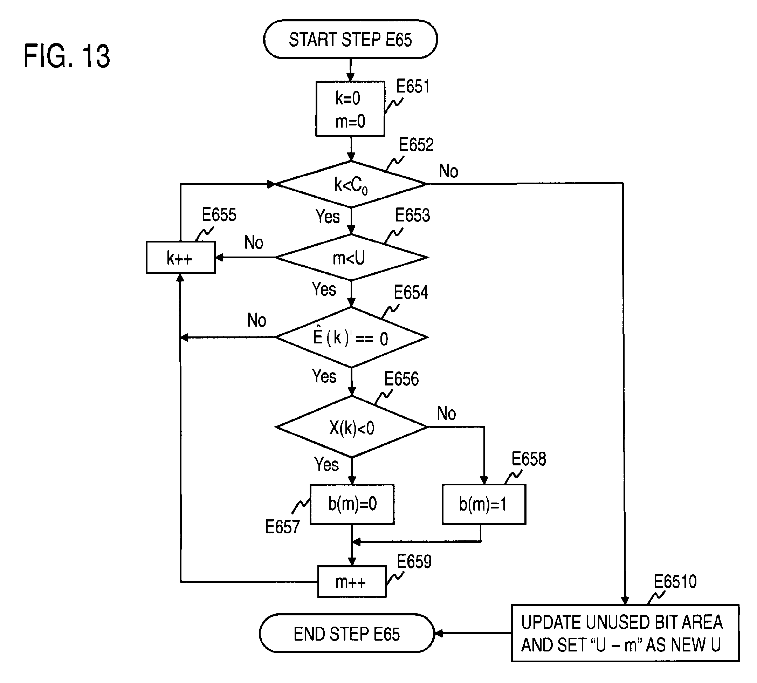

A simple example for simplifying the process is described. Assuming that human auditory perceptual characteristics become lower in a higher frequency region, the sign information corresponding to the number of unused bits, U, is written over the unused bit region in order from a lower frequency. In this example, the sign information output unit 1184 performs the process illustrated in Fig. 13, and writes the sign information of a sample that makes the quantized value $\hat{E}(k)'$ zero, of the input signal $X(k)$ in the frequency domain, into the unused bit region. Note that Fig. 13 illustrates the process on the $C_0$ samples. That is, when $C_0$ is L, the process of Step E65 in Fig. 13 is executed for each frame. When $C_0$ is a common divisor of L other than one and L, the process of Step E65 in Fig. 13 is repeatedly executed for each sub-band in one frame.

The sign information output unit 1184 initializes k and m as k=0 and m=0, and proceeds to Step E52 (Step E651).

The sign information output unit 1184 compares k with $C_0$ (Step E652); if k is less than $C_0$, the sign information

output unit 1184 proceeds to Step E653; if k is not less than $C_0$, the sign information output unit 1184 sets a region obtained by subtracting a region in which bits b(m) are placed from the unused bit region, as a new unused bit region, sets U - m as a new value ofU (Step E6510), and exits the process of Step E65. Note that, when $C_0$ is L, Step E6510 need not be executed.

The sign information output unit 1184 compares m with U (Step E653); and if m is less than U, the sign information output unit 1184 proceeds to Step E654 or, if m is not less than U, the sign information output unit 1184 increments k by one (Step E655), and proceeds to Step E652.

In Step E654, the sign information output unit 1184 determines whether or not $E^{\wedge}(k)$' is zero (Step E654); and if $E^{\wedge}(k)$' is not zero, then the quantization-candidate calculator 1181 increments k by one (Step E655), and proceeds to Step E652. If $E^{\wedge}(k)$' is zero, the quantization-candidate calculator 1181 compares X(k) with zero (Step E656); if X(k) is less than zero, the quantization-candidate calculator 1181 writes zero into the m-th bit b(m) in the unused bit region (Step E658), and proceeds to Step E659. If X(k) is not less than zero, the quantization-candidate calculator 1181 writes one into the m-th bit b(m) in the unused bit region (Step E658), and proceeds to Step E659. In Step E659, the quantization-candidate calculator 1181 increments m by one (Step E659), increments k by one (Step E655), and proceeds to Step S652 (the end of the description of [Example of Step E665]).

A code (bit stream) corresponding to a modified vector quantization index (vqi') containing the vector quantization index and the sign information written into the unused bit region is sent to the decoding device (the end of the description of [Example 2 of Step E6]).

Note that, in the case of adopting, for the vector quantizer 1182 in Example 1 or 2 of Step E6, a quantizing method in which the quantized value E(k)' may not be zero even when the quantization candidate E(k) is zero, the vector quantizer 1182 may vector-quantize only the quantization candidates E(k) having a value other than zero, and the sign information output unit 1184 may output the sign information of a sample that makes the quantization candidate E(k) zero, of the input signal X(k) in the frequency domain. In this case, however, it is necessary to output and send, to the decoding device, the sample identification number k of the sample that makes the quantization candidate E(k) zero or the sample identification number k of a sample that does not make the quantization candidate E(k) zero. For this reason, it is preferable that a vector quantizing method in which the quantized value E(k)' is always zero when the quantization candidate E(k) is zero be adopted for the vector quantizer 1182.

<Decoding Process>

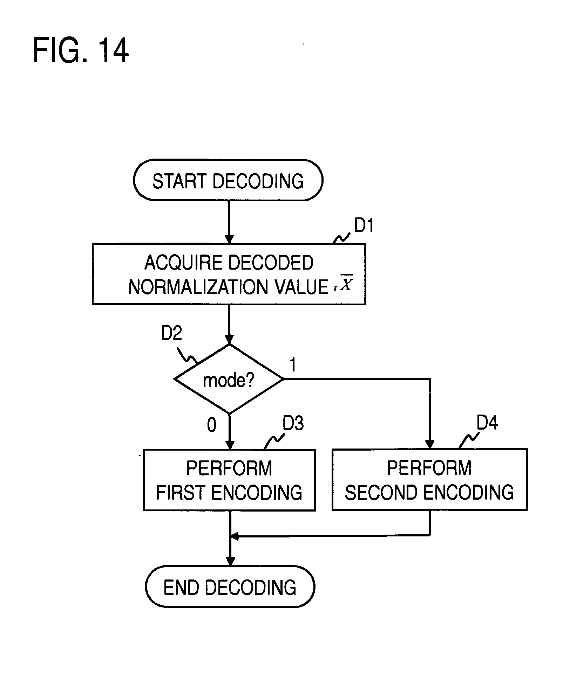

The decoding device 12 (Fig. 1) executes steps in a decoding method illustrated in Fig. 14.

The normalization value decoder 123 obtains a decoded normalization value $_\tau X^-$ corresponding to the normalization-value quantization index input to the decoding device 12 (Step D1).

It is assumed here that a codebook storage not shown in the figure contains normalization values individually corresponding to a plurality of normalization-value quantization indices. The normalization value decoder 121 searches the codebook storage using the input normalization-value quantization index as a key to obtain the normalization value corresponding to the input normalization-value quantization index, as the decoded normalization value $_\tau X^-$. The decoded normalization value $_\tau X^-$ is sent to the first decoder 127 and the second decoder 128.

The switching units 125 and 126 determine a decoding mode in accordance with the input mode information s (Step D2).

When s is zero (when the samples are sparse), the switching units 125 and 126 send the vector quantization index input to the decoding device 12 to the first decoder 127. The first decoder 127 uses $_\tau X^-$ to obtain a value $X^{\wedge}(k)$ of a decoded signal from the vector quantization index by the predetermined first decoding mode, such as the described first mode, and outputs $X^{\wedge}(k)$ (Step D3).

When s is one (when the samples are not sparse), the switching units 125 and 126 send the vector quantization index input to the decoding device 12 to the second decoder 128. The second decoder 128 uses $_\tau X^-$ to obtain a value $X^{\wedge}(k)$ of a decoded signal of a decoded signal (or $X^{\wedge}_{POST}(k)$) from the vector quantization index by the predetermined second decoding mode, and outputs $X^{\wedge}(k)$ (Step D4).

When a decoded signal in the time domain is needed, $X^{\wedge}(k)$ (or $X^{\wedge}_{POST}(k)$) output from the first decoder 127 or the second decoder 128 are input to the time-domain converter 121, the time-domain converter 121 transforms them into the time-domain signal z(n) by an inverse Fourier transform, for example, and outputs the time-domain signal z(n).

[Example 1 of Step D4]

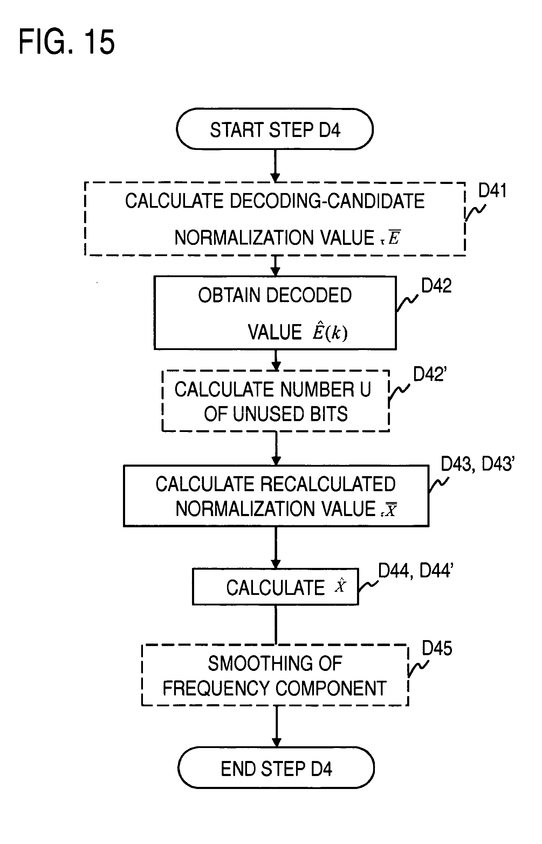

In Example 1 of Step D4, the second encoder 118 performs encoding described in the [Example 1 of Step E6]. In Example 1 of Step D4, the second encoder 118 receives a decoded normalization value $\tau X^-$ and the vector quantization index and performs steps illustrated in Fig. 15.

The vector decoder 1282 (Fig. 3) obtains a plurality of values corresponding to the vector quantization index as a plurality of decoded values $E^{\wedge}(k)$ (Step D42). The decoded values $E^{\wedge}(k)$ are sent to the synthesizer 1283.

It is assumed here that a vector codebook storage not shown in the figure contains the representative quantization vectors individually corresponding to a plurality of vector quantization indices. The vector decoder 1282 searches the vector codebook storage using the representative quantization vector corresponding to the input vector quantization index as a key to obtain the representative quantization vector corresponding to the vector quantization index. The components of the representative quantization vector are a plurality of values corresponding to the input vector quantization index.

The normalization value recalculator 1281 calculates a recalculated normalization value $_\tau X^=$ that takes on a value that decreases with increasing sum of the absolute values of a predetermined number of decoded values $E^{\wedge}(k)$ (step D43). The recalculated normalization value is sent to the synthesizer 1283. The recalculated normalization value $_\tau X^=$ is the character $_\tau X$ with a double overline.

[Example of Step D43]

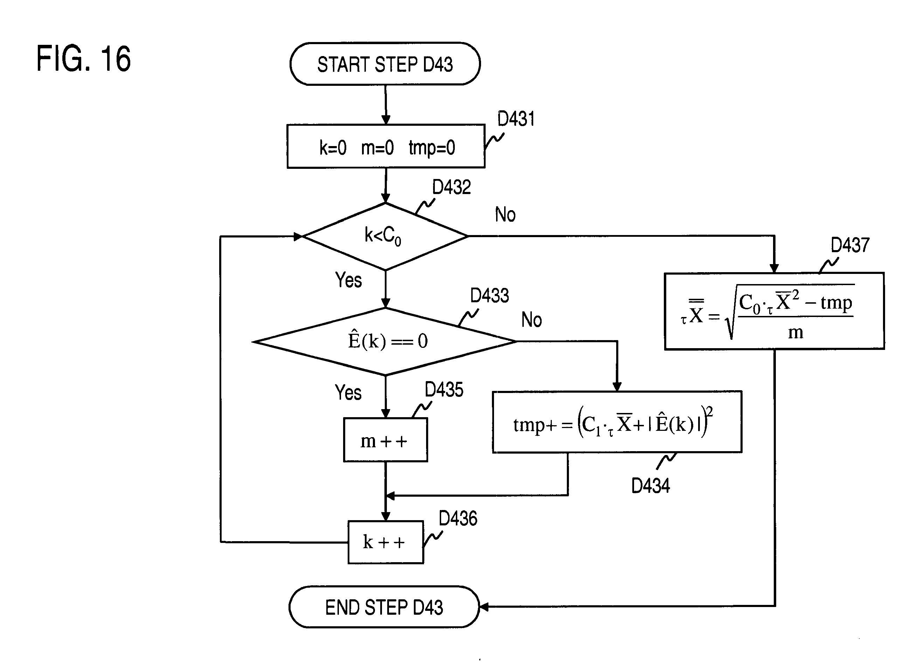

In particular, the normalization value recalculator 1281 performs the operations illustrated in Fig. 16 to obtain the recalculated normalization value $X^=$. The recalculated normalization value $X^=$ denotes a representative value of samples whose quantization candidates $E(k)$ were set to zero in coding. In this example, the recalculated normalization value $X^=$ is calculated by subtracting the sum tmp of the powers of samples whose quantization candidate $E(k)$ were not set to zero in coding from the sum $C_0 X^{-2}$ of the powers of $C_0$ samples, by dividing the difference by the number m of the samples whose quantization candidates $E(k)$ were set to zero, and by extracting the square root of the quotient, as shown in Equation (2) given below

The normalization value recalculator 1281 initializes the characters k, m and tmp as k = 0, m = 0 and tmp = 0 (step D431).

The normalization value recalculator 1281 compares k with $C_0$ (step D432); and if $\geq C_0$, the value of $X^=$ defined by the following equation is calculated (step D437), then the process at step D43 exits.

$$_\tau \overline{\overline{X}} = \sqrt{\frac{C_0 \cdot {}_\tau \overline{X}^2 - \mathrm{tmp}}{m}} \qquad (2)$$

If k is less than $C_0$, the normalization value recalculator 1281 determines whether or not the decoded value $E^{\wedge}(k)$ is zero (Step D433); if $E^{\wedge}(k)$ is zero, the normalization value recalculator 1281 increments m by one (step D435), and proceeds to step D436 or, if the decoded value $E^{\wedge}(k)$ is not zero, the normalization value recalculator 1281 proceeds to step D434.

The normalization value recalculator 1281 calculates the power of the sample with number k and adds the power to tmp (step D434). The normalization value recalculator 1281 proceeds to step D436. That is, the sum of the calculated power and the value of tmp is set as a new value of tmp. The power is calculated according to the following equation, for example.

$$\left( C_1 \cdot {}_\tau \overline{X} + | \hat{E}(k) | \right)^2$$

The normalization value recalculator 1281 increments k by one (Step D436) and proceeds to Step D432 (the end of the description of [Example of Step D43]).

To obtain a decoded signal value $X^{\wedge}(k)$, the synthesizer 1283 calculates the linear sum of the decoded value $E^{\wedge}(k)$ and the decoded normalization value $_\tau X^-$ when the decoded value $E^{\wedge}(k)$ is positive, the synthesizer 1283 reverses the sign of the linear sum of the absolute value of the decoded value $E^{\wedge}(k)$ and the decoded normalization value $_\tau X^-$ when the decoded value $E^{\wedge}(k)$ is negative or, the synthesizer 1283 multiplies the recalculated normalization value $_\tau X^=$ by a first constant $C_3$ and randomly inverts the sign of the product when the decoded value $E^{\wedge}(k)$ is zero(step D44).

[Example of Step D44]

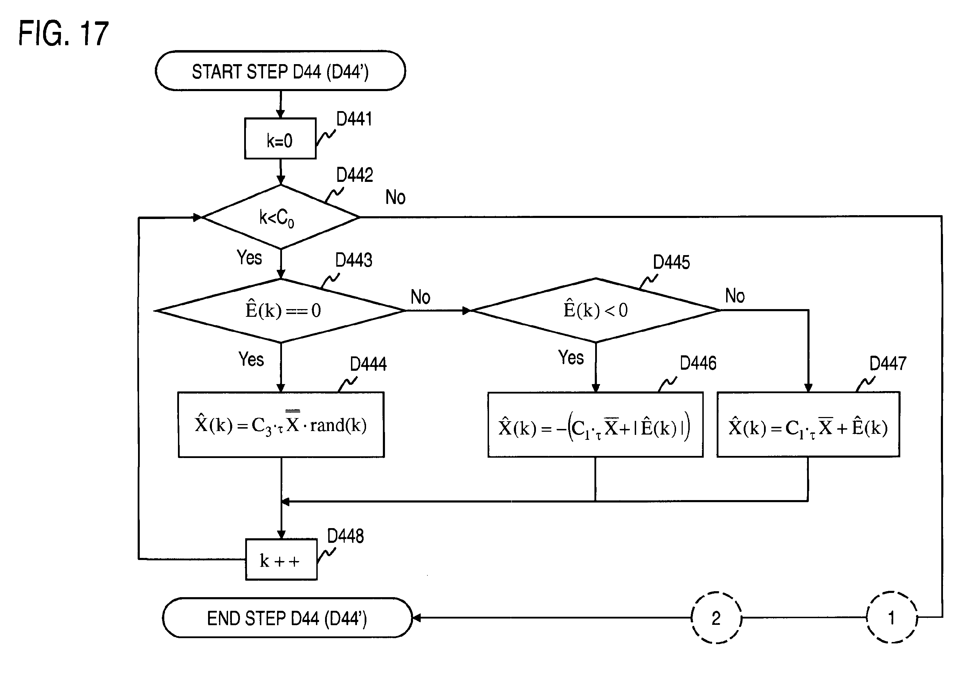

The synthesizer 1283 obtains a decoded signal by performing process illustrated in Fig. 17, for example. When $C_0$ is L, the process of Step E44 illustrated in Fig. 17 is performed for each frame; when $C_0$ is a common divisor of L other than one and L, the process of Step D44 illustrated in Fig. 17 is repeatedly performed for each sub-band included in one frame.

The synthesizer 1283 initializes character k as k = 0 (step D441).

The synthesizer 1283 compares k with $C_0$ (step D442); if not k < $C_0$, the process at step D44 exits; if k < $C_0$, the synthesizer 1283 compares the decoded value $E^{\wedge}(k)$ with zero (step D443); if the decoded value $E^{\wedge}(k)$ is zero, the synthesizer 1283 multiplies the recalculated normalization value ${}_\tau X^=$ by the first constant $C_3$ and randomly inverts the sign of the product to obtain the value $X^{\wedge}(k)$ (value having the magnitude corresponding to the recalculated normalization value) of the decoded signal (step D444). That is, the synthesizer 1283 calculates the value defined by the equation given below to obtain $X^{\wedge}(k)$. Here, $C_3$ is a constant for adjusting the magnitude of the frequency component and may be 0.9, for example. The rand (k) is a function that outputs 1 or -1, for example randomly outputs 1 or -1 based on random numbers.

$$\hat{X}(k) = C_{3\cdot\tau}\overline{\overline{X}} \cdot \text{rand}(k)$$

If the synthesizer 1283 determines at step D443 that the decoded value $E^{\wedge}(k)$ is not zero, the synthesizer 1283 compares the decoded value $E^{\wedge}(k)$ with zero (step D445); and if the decoded value $E^{\wedge}(k) < 0$, the synthesizer 1283 reverses the sign of the sum of the absolute value $|E^{\wedge}(k)|$ of the decoded value $E^{\wedge}(k)$ and the product $C_{1\cdot\tau}X^-$ of a constant $C_1$ and the decoded normalization value ${}_\tau X^-$ (reverses the sign of the liner sum of the absolute value $|E^{\wedge}(k)|$ of the decoded value $E^{\wedge}(k)$ and the decoded normalization value ${}_\tau X^-$) to obtain a value $X^{\wedge}(k)$ of the decoded signal (step D446). That is, the synthesizer 1283 calculates the value defined by the following equation to obtain $X^{\wedge}(k)$.

$$\hat{X}(k) = -\left(C_{1\cdot\tau}\overline{X} + |\hat{E}(k)|\right)$$

If the decoded value $E^{\wedge}(k)$ is not less than zero, the synthesizer 1283 adds the decoded value $E^{\wedge}(k)$ to the product $C_{1\cdot\tau}X^-$ of the constant $C_1$ and the decoded normalization value ${}_\tau X^-$ (the liner sum of the absolute value $|E^{\wedge}(k)|$ of the decoded value $E^{\wedge}(k)$ and the decoded normalization value ${}_\tau X^-$) to obtain $X^{\wedge}(k)$ (step D447). That is, the synthesizer 1283 calculates the value defined by the following equation to obtain $X^{\wedge}(k)$.

$$\hat{X}(k) = C_{1\cdot\tau}\overline{X} + \hat{E}(k)$$

After $X^{\wedge}(k)$ is determined, the synthesizer 1283 increments k by one (Step D448) and proceeds to Step D442 (the end of the description of [Example of Step D44]).

When a time-domain decoded signal is needed, $X^{\wedge}(k)$ output from the synthesizer 1283 are input to the time-domain converter 121, and the time-domain converter 121 transforms $X^{\wedge}(k)$ into time-domain signals z(n) by an inverse-Fourier transform, for example, and outputs the time-domain signal (the end of the description of [Example 1 of Step D4]).

[Example 2 of Step D4]

In Example 1 of Step D4, the second decoder 118 performs encoding described in the [Example 2 of Step E6]. In Example 2 of Step D4, the second decoder 118 receives the decoded normalization value ${}_\tau X^-$ and the modified vector quantization index and performs steps illustrated in Fig. 15.

The vector decoder 1282' (Fig. 3) obtains, as the plurality of decoded values $E^{\wedge}(k)$, a plurality of values corresponding to the vector quantization index contained in the modified vector quantization index. The vector decoder 1282' calculates the number of unused bits, U, using the vector quantization index (Step D42'). In addition, the vector decoder 1282' calculates, as the number of unused bits, U, the bit number of bits that are not used in actual vector quantization, among the bits assigned for the vector quantization. In the present example, the number of unused bits, U, is calculated for each frame (on an L-sample basis). For example, the vector decoder 1282' subtracts, from the bit number assigned for the vector quantization in a frame to be processed, the total bit number of the vector quantization index corresponding to the frame, and sets the resultant value as the number of unused bits, U. The decoded value $E^{\wedge}(k)$ and the number of unused bits, U, are sent to the synthesizer 1283'.

The normalization value recalculator 1281 calculates a recalculated normalization value ${}_\tau X^=$ having a smaller value as the sum of absolute values of a predetermined number of the decoded values $E^{\wedge}(k)$ is larger (Step D43). The calculated recalculated normalization value ${}_\tau X^=$ is sent to the synthesizer 1283'.

To obtain a value $X^{\wedge}(k)$ of the decoded signal, the synthesizer 1283' calculates the linear sum of the decoded

value $E^{\wedge}(k)$ and the decoded normalization value $_\tau X^-$ when decoded value $E^{\wedge}(k)$ is positive, the synthesizer 1283' reverses the sign of the linear sum of the absolute value of decoded value $E^{\wedge}(k)$ and the decoded normalization value $_\tau X^-$ when the decoded value $E^{\wedge}(k)$ is negative or, the synthesizer 1283' calculates a value (a value having a magnitude corresponding to the recalculated normalization value $_\tau X^=$) that is obtained by multiplying the normalization recalculated value $_\tau X^=$ by a first constant $C_3$ or obtained by reversing the sign of the multiplication value when decoded value $E^{\wedge}(k)$ is zero.

Here, for a sample that makes the decoded value $E^{\wedge}(k)$ zero and whose sign is expressed by the sign information contained in the modified vector quantization index, the sign of $X^{\wedge}(k)$ of the sample is identified by the corresponding the sign information. That is, for a sample that makes the decoded value $E^{\wedge}(k)$ zero and is expressed as positive by the sign information, the multiplication value of the normalization recalculated value $_\tau X^-$ and the first constant $C_3$ is $X^{\wedge}(k)$. For a sample that makes the decoded value $E^{\wedge}(k)$ zero and is expressed as negative by the sign information, the sign reversed value of the multiplication value of the normalization recalculated value $_\tau X^=$ and the first constant $C_3$ is $X^{\wedge}(k)$. Further, for a sample that makes the decoded value $E^{\wedge}(k)$ zero and whose sign is not identified by the sign information, the sign of $X^{\wedge}(k)$ is randomly determined. That is, a value obtained by randomly inverting the sign of the multiplication value of the normalization recalculated value $_\tau X^=$ and the first constant $C_3$ is $X^{\wedge}(k)$ (Step D44'). In the present embodiment, the sign of $X^{\wedge}(k)$ can be identified by the sign information that is transmitted using the unused bit region, and hence the quality of $X^{\wedge}k$) can be enhanced.

[Example 1 of Step D44']

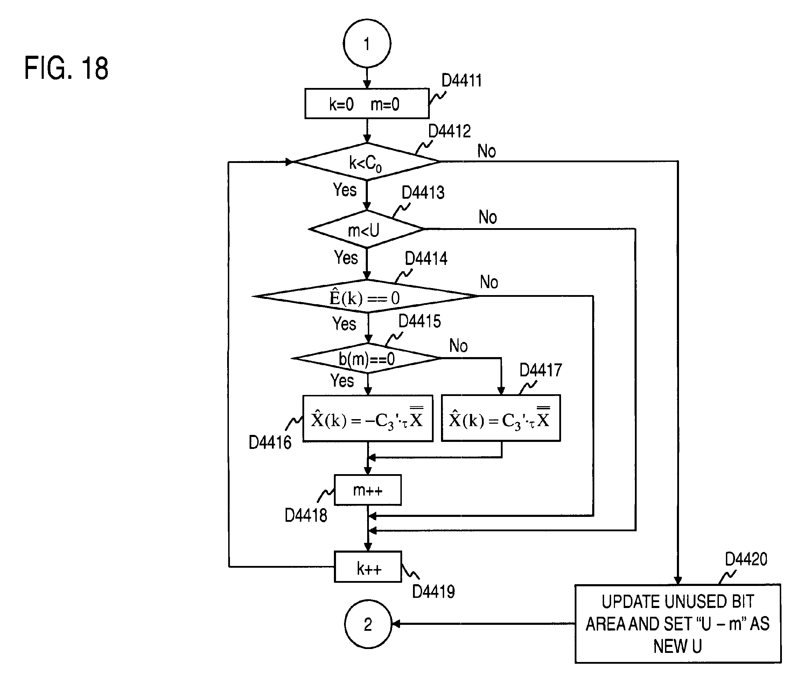

The synthesizer 1283' performs, for example, the process illustrated in in Figs. 17 and 18, to thereby obtain the decoded signal. When $C_0$ is L, the process of Step D44' in Figs. 17 and 18 is executed for each frame. When $C_0$ is a common divisor of L other than one and L, the process of Step D44' in Figs. 17 and 18 is repeatedly executed for each sub-band in one frame.

The process of Steps D441 to D448 is as described above. However, in Example 1 of Step D44', when it is determined in Step D442 that k is not less than $C_0$, the process proceeds to Step D4411

In Step D4411, the synthesizer 1283' initializes k and m as k = 0 and m = 0 (Step D4411). Next, the synthesizer 1283' compares k with $C_0$ (Step D4412); and if k is not less than $C_0$, then the synthesizer 1283' sets a region obtained by subtracting a region in which the bits b(m) are placed from the unused bit region, as a new unused bit region, sets U - m as a new value of U (Step D4420), and exits the process of Step D44'. When $C_0$ is L, Step D4420 need not be executed. Ifk is less than $C_0$, the synthesizer 1283' compares m with the number of unused bits, U (Step D4413); and if m is not less than U, the synthesizer 1283' increments k by one (Step D4419) and proceeds to Step D4412. If m is less than U, the synthesizer 1283' determines whether or not the decoded value $E^{\wedge}(k)$ is zero (Step D4414), and if $E^{\wedge}(k)$ is not zero, the synthesizer 1283' increments k by one (Step D4419) and proceeds to Step D4412. If $E^{\wedge}(k)$ is zero, the synthesizer 1283' determines whether or not the input m-th bit b(m) of the unused bit region is zero (Step D4415), and if b(m) is zero, the synthesizer 1283' sets a value (a value having a magnitude corresponding to the normalization recalculated value $_\tau X^=$) obtained by inverting the sign of the multiplication value of the normalization recalculated value $_\tau X^=$ and a constant $C_3'$, as the value $X^{\wedge}(k)$ of the decoded signal (Step D4416). $C_3'$ is a constant that adjusts the magnitude of frequency components, and $C_3'$ is, for example, equal to $C_3$ or $\varepsilon \cdot C_3$. $\varepsilon$ is a constant or a variable determined in accordance with other process. That is, the synthesizer 1283' sets, as $X^{\wedge}(k)$, a value defined by the following formula.

$$\hat{X}(k) = -C_3' {\cdot}_\tau \overline{\overline{X}} \qquad (3)$$

Note that, in the process in Step D4416, only the sign of $X^{\wedge}(k)$ obtained (obtained in Step D444 in this example) may be modified, only the sign of a value obtained by changing the amplitude of $X^{\wedge}(k)$ obtained may be modified, and Formula (3) may be newly calculated. After Step D4416, the synthesizer 1283' increments each of m and k by one (Steps D4418 and D4419), and proceeds to Step D4412.

If it is determined in Step D4415 that b(m) is not zero, the synthesizer 1283' sets the multiplication value of the recalculated normalization value $_\tau X^=$ and the constant C', as the value $X^{\wedge}(k)$ of the decoded signal (Step D4417). That is, the synthesizer 1283' sets, as $X^{\wedge}(k)$, a value defined by the following formula

$$\hat{X}(k) = C_3' {\cdot}_\tau \overline{\overline{X}} \qquad (4)$$

Note that, in the process in Step D4417, only the sign of $X^{\wedge}(k)$ obtained may be modified, only the sign of a value obtained by changing the amplitude of $X^{\wedge}(k)$ obtained may be modified, and Formula (4) may be newly calculated. After Step D4417, the synthesizer 1283' increments each of m and k by one (Steps D4418 and D4419), and proceeds to Step D4412 (End of the description of [Specific Example of Step D44']).

[Example 2 of Step D44']

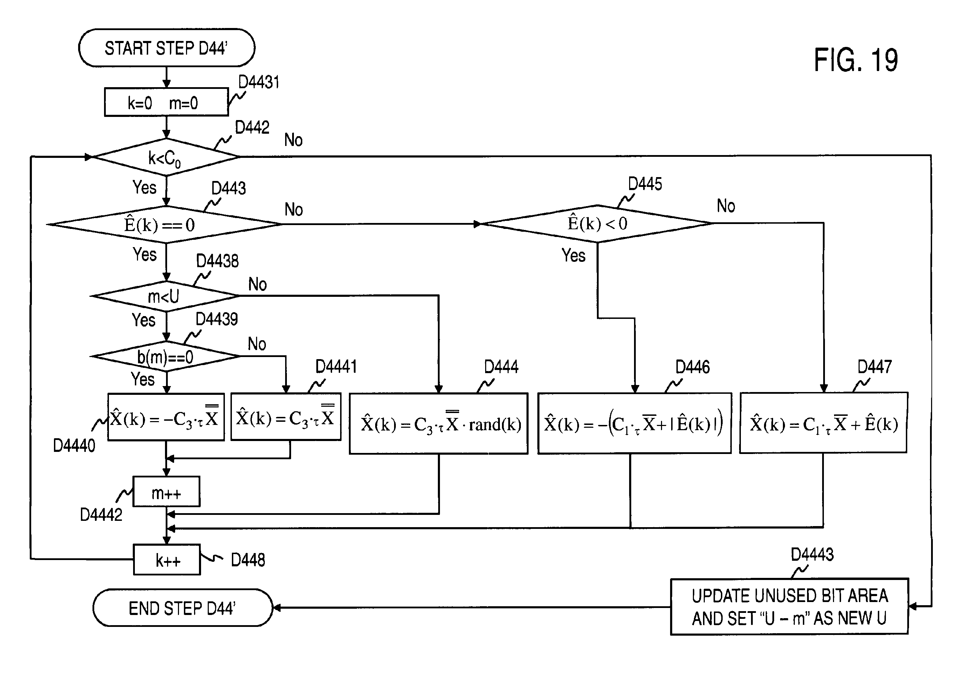

The synthesizer 1283' may obtain a decoded signal by performing process represented in Fig. 19. Here, the process of Step D44' illustrated in Fig. 19 is performed for each frame when $C_0$ is L or, the process of Step D44' illustrated in Fig. 19 is repeatedly performed for each sub-band included in one frame when $C_0$ is a common divisor of L other than one and L.

The synthesizer 1283' initializes k and m as k = 0 and m = 0 (Step D4431).

The synthesizer 1283' compares k with $C_0$ (Step D442), and if k is not less than $C_0$, the synthesizer 1283' sets a region obtained by subtracting a region in which the bits b(m) are placed from the unused bit region, as a new unused bit region, sets U - m as a new value of U (Step D4443), and exits the process of Step D44'. Note that, if $C_0$ is L, Step D4443 need not be executed. If k is less than $C_0$, the synthesizer 1283' determines whether or not the decoded value $E^{\wedge}(k)$ is zero (Step D443); if the decoded value $E^{\wedge}(k)$ is zero, the synthesizer 1283' compares m with the number of unused bits, U (Step D4438); and if m is not less than U, the synthesizer 1283' sets a value obtained by randomly inverting the sign of the multiplication value of the recalculated normalization value $_\tau \overline{\overline{X}}$ and the first constant $C_3$, as the value $X^{\wedge}(k)$ of the decoded signal (Step D444). That is, the synthesizer 1283' calculates, as $X^{\wedge}(k)$, a value defined by the following formula.

$$\overset{\wedge}{X}(k) = C_3 \cdot {}_\tau \overline{\overline{X}} \cdot \text{rand}(k)$$

After Step D444, the synthesizer 1283' increments k by one (Step D448) and proceeds to Step D442.

If it is determined in Step D4438 that m is less than U, the synthesizer 1283' determines whether or not the m-th bit b(m) in the unused bit region, of the input modified vector quantization index, is zero (Step D4439); and if b(m) is zero, the synthesizer 1283' sets a value (value having the magnitude corresponding to the recalculated normalization value) obtained by inverting the sign of the multiplication value of the recalculated normalization value $_\tau \overline{\overline{X}}$ and the first constant $C_3$, as the value $X^{\wedge}(k)$ of the decoded signal (Step D4440). That is, the synthesizer 1283' calculates, as $X^{\wedge}(k)$, a value defined by the following formula.

$$\overset{\wedge}{X}(k) = -C_3 \cdot {}_\tau \overline{\overline{X}}$$

Note that the position of the m-th bit b(m) in the unused bit region, of the modified vector quantization index, can be easily identified if a start bit position of the unused bit region and the placement order of the bits b(m) are determined and the unused bit number U is obtained. After Step D4440, the synthesizer 1283' increments m and k by one, respectively (Steps D4442 and D448) and proceeds to Step D442.

If it is determined in Step D4439 that b(m) is not zero, the synthesizer 1283' sets the multiplication value (a value that has a magnitude corresponding to the recalculated normalization value $_\tau \overline{\overline{X}}$ of the recalculated normalization value $_\tau \overline{\overline{X}}$ and the first constant $C_3$, as the value $X^{\wedge}(k)$ of the decoded signal (Step D4441). That is, the synthesizer 1283' calculates, as $X^{\wedge}(k)$, a value defined by the following formula.

$$\overset{\wedge}{X}(k) = C_3 \cdot {}_\tau \overline{\overline{X}}$$

After Step D4441, the synthesizer 1283' increments m and k by one, respectively (Steps D4442 and D448) and proceeds to Step D442.

If it is determined in Step D443 that the decoded value $E^{\wedge}(k)$ is not zero, the synthesizer 1283' performs the process of the Steps D445 to D447, increments k by one (Step D448), and proceeds to Step D442 (the end of the description of [Example 2 of Step D44']).

When a decoded signal in a time domain is necessary, $X^{\wedge}(k)$ output from the synthesizer 1283' is input to the time-domain converter 121. The time-domain converter 121 transforms $X^{\wedge}(k)$ into a time-domain signal z(n) according to inverse MDCT, for example, and outputs the resultant signal (the end of the description of [Example 2 of Step D4]).

<Features of This Embodiment>

As described above, in the embodiments, the encoding mode and decoding mode are changed depending on whether or not the input signal is sparse. Accordingly, the appropriate encoding mode and decoding mode can be selected depending on whether or not the suppression of the musical noise and the like are necessary.

As described above, in the present embodiments, when the decoded value $E^(k)$ is zero, a value other than zero is assigned to $X^(k)$ using the recalculated normalization value $_\tau X^=$, and hence a spectral hole can be prevented from occurring when the input signal is, for example, a frequency-domain signal. This can reduce the musical noise and the like.

Further, when the sign information is transmitted to the decoding device 12 using the unused bit region that is not used for the vector quantization by the encoding device 11, the decoding device 12 can identify the sign of $X^(k)$ using the sign information transmitted in the unused bit region, and hence the quality of $X^(k)$ can be enhanced.

Note that, because the upper limit of the bit number of the sign information written into the unused bit region is the number of unused bits, U, the sign information corresponding to every frequency is not necessarily written into the unused bit region. In this case, the sign information is extracted in accordance with criteria defined by considering human auditory perceptual characteristics, and the extracted sign information is written into the unused bit region, whereby the decoding device 12 can correctly identify the sign of $X^(k)$ at frequencies that are important in terms of, for example, the human auditory perceptual characteristics. As a result, the quality of $X^(k)$ at the frequencies that are important in terms of the human auditory perceptual characteristics can be preferentially enhanced.

In addition, the signs of $X^(k)$ at frequencies at which the sign information cannot be transmitted are randomly determined using the function rand(k), and thus are not constant. Accordingly, a natural decoded signal can be made even for the frequencies at which the sign information cannot be transmitted.

[Other Modified Examples]

The present inventions are not limited to the above-described embodiments. Hereinafter modified examples other than those described above will be represented.

As indicated by a broken line in Fig. 2, the second encoder 118 may be provided with the quantization-candidate normalization value calculator 1183 that calculates a quantization-candidate normalization value $_\tau E^-$ that is a value representative of the quantization candidates E(k). Then, the vector quantizer 1182 or 1282 may collectively vector-quantize a plurality of values obtained by normalizing the quantization candidates E(k) respectively corresponding to a plurality of samples using the quantization-candidate normalization value $_\tau E^-$, to thereby obtain the vector quantization index. An example of the values obtained by normalizing the quantization candidates E(k) using the quantization-candidate normalization value $_\tau E^-$ includes a value $E(k)/_\tau E^-$ that is obtained by dividing E(k) by $_\tau E^-$. Because the quantization candidate E(k) is normalized and then vector-quantized, the dynamic range of the vector quantization candidate can be narrowed, and encoding and decoding with a smaller bit number are possible.

The quantization-candidate normalization value calculator 1183 uses, for example, the quantized normalization value $_\tau X^-$ to calculate a value defined by the following formula, as the quantization candidate E(k) (Fig. 11 / Step E61). $C_2$ is a positive adjustment factor (may be referred to as second constant), and is, for example, 0.3.

$$_\tau \overline{E} = C_2 \cdot _\tau \overline{X}$$

In this way, because the quantization-candidate normalization value $_\tau E^-$ is calculated from the quantized normalization value $_\tau X^-$, the decoding device can calculate the quantization-candidate normalization value $_\tau E^-$ from the quantized normalization value $_\tau X^-$ without transmission of information on the quantization-candidate normalization value $_\tau E^-$. Accordingly, the need to transmit the information on the quantization-candidate normalization value $_\tau E^-$ is eliminated, and the volume of communication can be reduced.

In this case, as indicated by a broken line in Fig. 3, the second decoder 128 is provided with the decoding-candidate normalization value calculator 1284. The decoding-candidate normalization value calculator 1284 multiplies the decoded normalization value $_\tau X^-$ by the second constant $C_2$ to obtain the resultant value as a decoding-candidate normalization value $_\tau E^-$ (Fig. 15 / Step D41). The decoding-candidate normalization value $_\tau E^-$ is sent to the vector decoder 1282 or 1282'. Then, the vector decoder 1282 or 1282' denormalizes, using $_\tau E^-$, a plurality of values corresponding to the vector quantization index to obtain the resultant values as the plurality of decoded values $E^(k)$. For example, the vector decoder 1282 or 1282' multiplies each of the plurality of values corresponding to the vector quantization index by the decoding-candidate normalization value $_\tau E^-$ to obtain the resultant values as the plurality of decoded values $E^(k)$. Note that the decoded values $E^(k)$ in this modification are the values obtained by denormalizing the plurality of values corresponding to the vector quantization index, but the quantization values E^(k) may be values before such denormalization.

The second decoder 128 may include a normalization value recalculator 1281' instead of the normalization value recalculator 1281.

At step D43' (Fig. 15), when the recalculated normalization value X'= previously calculated is not zero, the normalization value recalculator 1281' may obtain a weighted sum of the recalculated normalization value X= and the previously recalculated normalization value X'= as the recalculated normalization value X=. If the recalculated normalization value X'= is zero, the normalization value recalculator 1281' does not perform the weighted summing of the recalculated normalization values, which is the smoothing of the recalculated normalization values.

If $C_0$ = L and a recalculated normalization value X= is calculated per each frame, the previously recalculated normalization value X'= is a recalculated normalization value calculated by the normalization value recalculator 1281' for the immediately previous frame. If $C_0$ is a divisor of L other than one and L and frequency components are divided into $L/C_0$ sub-bands and a recalculated normalization value is calculated per each sub-band, the previously recalculated normalization value X'= may be a recalculated normalization value calculated for the same sub-band in the immediately previous frame or may be a recalculated normalization value already calculated for the preceding or succeeding adjacent sub-band in the same frame.

The recalculated normalization value $X_{post}$= newly calculated by considering the previously recalculated normalization value X'= can be expressed by the equation given below, where $\alpha_1$ and $\beta_1$ are adjustment coefficients which are determined as appropriate according to the desired performance and specifications. For example, $\alpha_1 = \beta_1 = 0.5$.

$$\begin{cases} {}_\tau\overline{\overline{X}}_{POST} = {}_\tau\overline{\overline{X}} & \text{if} \quad {}_\tau\overline{\overline{X}}' = 0 \\ {}_\tau\overline{\overline{X}}_{POST} = \alpha_1 \cdot {}_\tau\overline{\overline{X}} + \beta_1 \cdot {}_\tau\overline{\overline{X}}' & \text{otherwise} \end{cases}$$

By obtaining a recalculated normalization value considering the previously recalculated normalization value X'=, the newly recalculated normalization value will be closer to the previously recalculated normalization value X'=. As a result the continuity between these values will increase and therefore the musical noise and the like caused when the input signal is the frequency-domain signal, etc., can be further reduced.

As indicated by a broken line in Fig. 3, the second decoder 128 may further include the smoothing unit 1285.

The smoothing unit 1285 receives, as its input, the value X^(k) of the decoded signal obtained in D44 or D44' (Fig. 15). When a value X^(k)' of a past decoded signal before the value X^(k) of the decoded signal is not zero, the smoothing unit 1285 outputs the weighted sum of the value X^(k)' of the past decoded signal and the value X^(k) of the decoded signal, as a smoothed value $X^\wedge_{POST}$(k). When X^(k)' is zero, the smoothing unit 1285 does not obtain the weighted sum of the values of the decoded signals, that is, does not perform smoothing of the values of the decoded signals, and outputs X^(k) as $X^\wedge_{POST}$(k) (Fig. 15 / Step D45). Examples of the value X^(k)' of the past decoded signal include: a value of a decoded signal that is obtained in Step D4 for one frame before the frame corresponding to the value X^(k) of the decoded signal; and a smoothed value that is obtained in Step D4' for one frame before the frame corresponding to the value X^(k) of the decoded signal.

$X^\wedge_{POST}$(k) is expressed as in the following formula. $\alpha_2$ and $\beta_2$ are adjustment factors, and are decided as appropriate in accordance with desired performance and specifications. $\alpha_2$ is equal to, for example, 0.85, and $\beta_2$ is equal to, for example, 0.15. $\varphi(\cdot)$ expresses the sign of :

$$\begin{cases} \hat{X}_{POST}(k) = \hat{X}(k) & \text{if} \quad \hat{X}(k)' = 0 \\ \hat{X}_{POST}(k) \\ = \{\alpha_2 \cdot |\hat{X}(k)| + \beta_2 \cdot |\hat{X}(k)'|\} \cdot \phi(\hat{X}(k)) & \text{otherwise} \end{cases}$$

This can reduce the musical noise and the like caused by the discontinuity in the time axis direction of amplitude characteristics of X^(k). When a decoded signal in a time domain is necessary, $X^\wedge_{POST}$(k) outputted from the smoothing unit 1285 is inputted to the time-domain converter 121. The time-domain converter 121 transforms $X^\wedge_{POST}$(k) into the time domain signal z(n) according to, for example, inverse MDCT, and outputs the resultant signal.

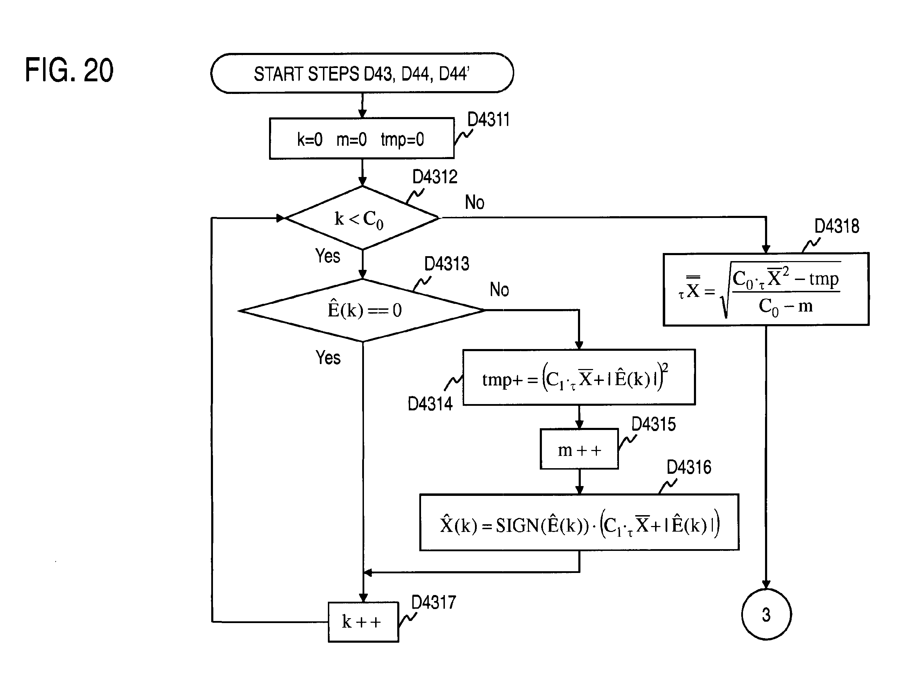

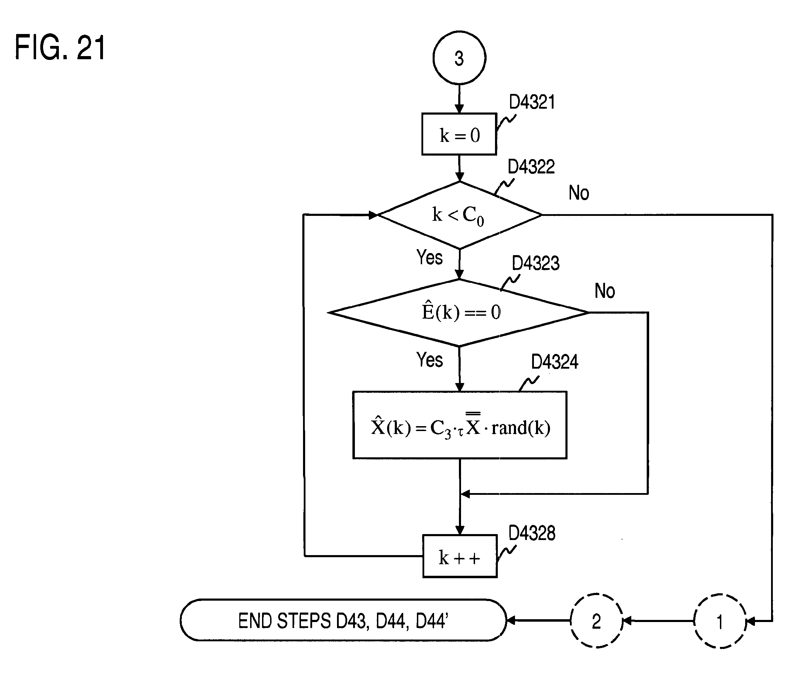

When the second decoder 128 includes a synthesizer 1286 instead of the synthesizer 1283 or 1283' and the normalization value recalculators 1281 and 1287, the synthesizer 424, for example, receives ${}_\tau$X⁻ and E^(k) and may perform the subsequent processes shown in Figs. 20 and 21 instead of Examples of Steps D43 and D44. When $C_0$ is L, the process described below is performed for each frame or, when $C_0$ is a common divisor of L other than one and L, the process described below is repeatedly performed for each sub-band in one frame.

The synthesizer 1286 initializes k, m, and tmp as k = 0, m = 0, and tmp = 0 (Step D4311).

The synthesizer 1286 compares k with $C_0$ (Step D4312); if k is less than $C_0$, the synthesizer 1286 determines whether or not the decoded value $\hat{E}(k)$ is zero (Step D4313); and if the decoded value $\hat{E}(k)$ is zero, the synthesizer 1286 increments k by one Step D4317), and proceeds to Step D4312. If the decoded value $\hat{E}(k)$ is not zero, the synthesizer 1286 calculates the power of the sample of the identification number k, and adds the calculated power to tmp (Step D4314). That is, the synthesizer 1286 sets a value obtained by adding the calculated power to a value of tmp, as a new value of tmp. For example, the the synthesizer 1286 calculates the power according to the following formula.

$$\left(C_1 \cdot {}_\tau\overline{X} + |\hat{E}(k)|\right)^2$$

Further, the synthesizer 1286 increments m by 1 (Step D4315), and calculates the following formula (Step D4316).

$$\hat{X}(k) = SIGN(\hat{E}(k)) \cdot \left(C_1 \cdot {}_\tau\overline{X} + |\hat{E}(k)|\right)$$

Note that SIGN($\hat{E}(k)$) is a function that is 1 when $\hat{E}(k)$ is positive and is -1 when $\hat{E}(k)$ is negative. After that, the synthesizer 1286 increments m by one (Step D4317), and goes to Step D4312.

If it is determined in Step D4312 that k is not less than $C_0$, the synthesizer 1286 calculates a value of ${}_\tau\overline{\overline{X}}$ defined by the following formula (Step D4318).

$${}_\tau\overline{\overline{X}} = \sqrt{\frac{C_0 \cdot {}_\tau\overline{X}^2 - tmp}{C_0 - m}}$$

Further, the synthesizer 1286 initializes k as k=0 (Step D4321).

The synthesizer 1286 compares k with $C_0$ (Step D4322), and if k is not less than $C_0$, the synthesizer 1286 exits the process of Steps D43 and D44. Ifk is less than $C_0$, the synthesizer 1286 determines whether or not the decoded value $\hat{E}(k)$ is zero (Step D4323), and if the decoded value $\hat{E}(k)$ is zero, the synthesizer 1286 sets a value obtained by randomly inverting the sign of the multiplication value of the recalculated normalization value ${}_\tau\overline{\overline{X}}$ and the first constant $C_3$, as the value $\hat{X}(k)$ of the decoded signal (Step D4324). That is, the synthesizer 1286 calculates, as $\hat{X}(k)$, a value defined by the following formula.

$$\hat{X}(k) = C_3 \cdot {}_\tau\overline{\overline{X}} \cdot rand(k)$$

Thereafter, the synthesizer 1286 increments k by one (Step D4328) and proceeds to Step D4322.

After that, the synthesizer 1286 increments k by one (Step D4328), and proceeds to Step D4322.

The synthesizer 424 may receive ${}_\tau X^-$, $\hat{E}(k)$, U, and b(m), and may perform the following process shown in Figs. 18, 20, and 21, instead of the above-described Examples of Steps D43 and D44', for example. A difference between the following process and the above-described process shown in Figs. 20 and 21 is that, when it is determined that k is not less than $C_0$ in Step D4322, instead of ending the process of Steps D43 and D44, the synthesizer 1286 proceeds to the process of Step D4411 shown in Fig. 18. The others are same as described above.

Furthermore, $C_0$, $C_1$, $C_2$, $C_3$, $\alpha_1$, $\beta_1$, $\alpha_2$, and $\beta_2$ may be changed as appropriate in accordance with desired performance and specifications.

In addition, the input signal X(k) does not necessarily need to be a frequency-domain signal, and may be a given signal such as a time-domain signal. That is, the present invention can be applied to encoding and decoding of a given signal other than a frequency-domain signal.

In addition, a normalization value $F_{GAIN}$ for the input signal X(k) may be determined for each frame, and the quantization-candidate calculator 1181 may use a value obtained by normalizing X(k) using the normalization value $F_{GAIN}$ in place of the value X(k) of each sample of the input signal, and may use a value obtained by normalizing ${}_\tau X^-$ using the normalization value $F_{GAIN}$ in place of the quantized normalization value ${}_\tau X^-$, to thereby execute the processing of Step E6. For example, the processing of Step E6 may be executed in the state where X(k) is replaced with X(k) / $F_{GAIN}$ and where $_\tau X^-$ is replaced with $_\tau X^- / F_{GAIN}$.

When normalization is performed using the normalization value $F_{GAIN}$, the process of Step E33 (Figs. 5 and 6), Step E336 (Figs. 7 and 8), and Step E346 (Figs. 9 and 10) may not be performed and the subsequent processes may be performed as $X^\sim(k) = X(k)$, $X^\sim(i \cdot C_0 + h) = X(i \cdot C_0 + h)$, and $X^\sim(b \cdot C_0 + h) = X(b \cdot C_0 + h)$.

In addition, when normalization is performed using the normalization value $F_{GAIN}$, the normalization value calculator 112 may not be provided and a value obtained by normalizing X(k) by the normalization value $F_{GAIN}$ may be input to the normalization value quantizer 113 instead of the quantized normalization value $_\tau X^-$. In such a case, the first encoder 117 and the second encoder 118 may perform encoding processes using a quantized value of a value obtained by normalizing X(k) by the normalization value $F_{GAIN}$, instead of quantized normalization value $_\tau X^-$. The normalization-value quantization index may correspond to the quantized value of a value that is normalized by the normalization value $F_{GAIN}$.

In addition, the various processes described above may be chronologically executed in the described order, and may be executed in parallel or individually as needed or in accordance with the processing capacity of an apparatus that executes the processes. Moreover, it goes without saying that the present invention can be changed as appropriate within the range not departing from the gist thereof.

[Hardware, Program, and Recording Medium]

The encoding device 11 and the decoding device 12 are configured by a known or special-purpose computer that includes a central processing unit (CPU) and a random access memory (RAM), and a special program in which the processing described above is written, for example. In that case, the special program is read into the CPU, and the CPU runs the special program to implement each function. The special program may be configured by a single program string or may carry out the objective by reading another program or library.

The program can be recorded on a computer-readable recording medium. Examples of the computer-readable recording medium include a magnetic recording apparatus, an optical disc, a magneto-optical recording medium, and a semiconductor memory. Examples of the computer-readable recording medium are non-transitory recording media. The program is distributed, for example, by selling, transferring, or lending a DVD, a CD-ROM, or other transportable recording media on which the program is recorded. The program may be stored in a storage unit of a server computer and may be distributed by transferring the program from the server computer to another computer through a network.

The computer that executes the program stores the program recorded on a transportable recording medium or the program transferred from the server computer, in its own memory. When the processing is executed, the computer reads the program stored in its own memory and executes the processing in accordance with the read program. The program may also be executed with other methods: The computer may read the program directly from the transportable recording medium and execute the processing in accordance with the program; and each time the program is transferred from the server computer to the computer, the processing may be executed according to the transferred program.

At least a part of the processing units of the encoding device 11 or the decoding device 12 may be configured by a special integrated circuit.

[DESCRIPTION OF REFERENCE NUMERALS]

| | |
|---|---|
| 11: | Encoding device |
| 111: | Frequency-domain converter |
| 112: | Normalization value calculator |
| 113: | Normalization value quantizer |
| 114: | Normalization value quantizer |
| 115,116: | Switching unit |
| 117: | First encoder |
| 118: | Second encoder |
| 12: | Decoding device |
| 123: | Normalization value decoder |
| 125,126: | Switching unit |
| 127: | First encoder |
| 128: | Second encoder |
| 121: | Normalization value decoder |

**Claims**

1. An encoding method comprising:

an encoding mode selecting step of selecting a second encoding mode when an evaluation value is a second reference value or less, selecting a first encoding mode other than the second encoding mode when the second encoding mode is not selected, and generating mode information representing a selected encoding mode, wherein the evaluation value corresponds to the number of samples which correspond to values less than a first reference value among a predetermined number of input samples, and the second encoding mode is a mode in which a normalization value that is a representative value of the predetermined number of samples is quantized to obtain a quantized normalization value and a normalization-value quantization index corresponding to the quantized normalization value, a difference value for each sample that is obtained by subtracting a value corresponding to the quantized normalization value from a value corresponding to the magnitude of a sample is set as a quantization candidate corresponding to the sample when the difference value is positive and the sample is positive, the sign of the difference value is reversed and the result is set to the quantization candidate corresponding to the sample when the difference value is positive and the sample is negative, and a plurality of quantization candidates are jointly vector-quantized to obtain a vector quantization index; and an encoding step of encoding the predetermined number of samples by the first encoding mode or the second encoding mode that is selected in the encoding mode selecting step,
**characterized in that**:

the first encoding mode is a mode in which the vector quantization index is obtained by vector-quantizing according to a vector quantization mode in which non-zero quantized values are obtained only for some of the predetermined number of samples and zero quantized values are obtained for the remaining samples; and
the second encoding mode includes a process of setting zero as the quantization candidate corresponding to each of the samples when the difference value is not positive.

2. The encoding method according to claim 1, wherein the evaluation value is a weighted addition value of an evaluation value calculated in previous time and the number of samples which correspond to values less than the first reference value.

3. The encoding method according to claim 1 or 2, wherein the second reference value when a previous predetermined number of samples are encoded by the first encoding mode is smaller than when the previous predetermined number of samples are encoded by the second encoding mode.

4. The encoding method according to claim 3, wherein the evaluation value is a value corresponding to the number of samples which include samples satisfying a criterion based on auditory perceptual characteristics and which correspond to values less than the first reference value among the predetermined number of samples.

5. The encoding method according to claim 1 or 2, wherein the evaluation value is a value corresponding to the number of samples which include samples satisfying a criterion based on auditory perceptual characteristics and which correspond to values less than the first reference value among the predetermined number of samples.

6. The encoding method according to claim 1, wherein the first encoding mode is a mode in which a normalization value that is representative of the predetermined number of samples is further quantized to obtain a quantized normalization value and a normalization-value quantization index corresponding to the quantized normalization value, and the non-zero quantized values are obtained only for some of the predetermined number of normalized samples that are obtained by normalizing the predetermined number of the samples by the quantized normalization value.

7. A decoding method comprising:

a switching step of selecting a second decoding mode when input mode information has a second value, and selecting a first decoding mode other than the second decoding mode when the mode information has a first value, wherein the second decoding mode is a mode in which a decoded normalization value corresponding to an input normalization-value quantization index is obtained, a plurality of values corresponding to an input vector quantization index are obtained as decoded values, a value having a magnitude corresponding to a recalculated normalization value that takes on a value that decreases with increasing sum of the absolute values of a predetermined number of the decoded values is obtained as a decoded signal when the decoded value is zero, a linear sum of the decoded value and the decoded normalization value is obtained as a decoded signal when the decoded value is positive, and a sign of the linear sum of the absolute value of the decoded value and the decoded normalization value is reversed and the result is set as a decoded signal when the decoded value is negative; and

a decoding step of performing a decoding process in the first decoding mode or the second decoding mode that is selected in the switching step,

**characterized in that**:

the first decoding mode is a mode in which the normalization-value quantization index is decoded to generate the decoded normalization value, the vector quantization index is decoded to generate a sample sequence, and a decoded signal sample sequence is obtained by multiplying the samples of the sample sequence by the decoded normalization value.

8. An encoding device (11) comprising:

an encoding mode selector (114) that selects a second encoding mode when an evaluation value is a second reference value or less, selects a first encoding mode other than the second encoding mode when the second encoding mode is not selected, and generates mode information representing a selected encoding mode, wherein the evaluation value corresponds to the number of samples which correspond to values less than a first reference value among a predetermined number of input samples, and the second encoding mode is a mode in which a normalization value that is a representative value of the predetermined number of samples is quantized to obtain a quantized normalization value and a normalization-value quantization index corresponding to the quantized normalization value, a difference value for each sample that is obtained by subtracting a value corresponding to the quantized normalization value from a value corresponding to the magnitude of a sample is set as a quantization candidate corresponding to the sample when the difference value is positive and the sample is positive, the sign of the difference value is reversed and the result is set to the quantization candidate corresponding to the sample when the difference value is positive and the sample is negative, and a plurality of quantization candidates are jointly vector-quantized to obtain a vector quantization index; and

an encoder (117, 118) that encodes the predetermined number of samples by the first encoding mode or the second encoding mode that is selected by the encoding mode selector (114),

**characterized in that**:

the first encoding mode is a mode in which the vector quantization index is obtained by vector-quantizing according to a vector quantization mode in which non-zero quantized values are obtained only for some of the predetermined number of samples and zero quantized values are obtained for the remaining samples; and

the second encoding mode includes a process of setting zero as the quantization candidate corresponding to each of the samples when the difference value is not positive.

9. The encoding device according to claim 8, wherein the evaluation value is a weighted addition value of an evaluation value calculated in previous time and the number of samples which correspond to values less than the first reference value.

10. The encoding device according to claim 8 or 9, wherein the second reference value when a previous predetermined number of samples are encoded by the first encoding mode is smaller than when the previous predetermined number of samples are encoded by the second encoding mode.

11. The encoding device according to claim 10, wherein the evaluation value is a value corresponding to the number of samples which include samples satisfying a criterion based on auditory perceptual characteristics and which correspond to values less than the first reference value among the predetermined number of samples.

12. The encoding device according to claim 8 or 9, wherein the evaluation value is a value corresponding to the number of samples which include samples satisfying a criterion based on auditory perceptual characteristics and which correspond to values less than the first reference value among the predetermined number of samples.

13. The encoding device according to claim 8, wherein the first encoding mode is a mode in which a normalization value that is representative of the predetermined number of samples is further quantized to obtain a quantized normalization value and a normalization-value quantization index corresponding to the quantized normalization value, and the non-zero quantized values are obtained only for some of the predetermined number of normalized samples that are obtained by normalizing the predetermined number of the samples by the quantized normalization value.

14. A decoding device (12) comprising:

a switching unit (125, 126) that selects a second decoding mode when input mode information has a second value, and selects a first decoding mode other than the second decoding mode when the mode information has a first value, wherein the second decoding mode is a mode in which a decoded normalization value corresponding to an input normalization-value quantization index is obtained, a plurality of values corresponding to an input vector quantization index are obtained as decoded values, a value having a magnitude corresponding to a recalculated normalization value that takes on a value that decreases with increasing sum of the absolute values of a predetermined number of the decoded values is obtained as a decoded signal when the decoded value is zero, a linear sum of the decoded value and the decoded normalization value is obtained as a decoded signal when the decoded value is positive, and a sign of the linear sum of the absolute value of the decoded value and the decoded normalization value is reversed and the result is set as a decoded signal when the decoded value is negative; and
a decoder (123, 127, 128) of performing a decoding process in the first decoding mode or the second decoding mode that is selected by the switching unit,

**characterized in that**:

the first decoding mode is a mode in which the normalization-value quantization index is decoded to generate the decoded normalization value, the vector quantization index is decoded to generate a sample sequence, and a decoded signal sample sequence is obtained by multiplying the samples of the sample sequence by the decoded normalization value.

15. A program for causing a computer to perform each step of the encoding method according to claim 1.

16. A program for causing a computer to perform each step of the decoding method according to claim 7.

17. A computer-readable recording medium on which a program for causing a computer to perform each step of the encoding method according to claim 1 is stored.

18. A computer-readable recording medium on which a program for causing a computer to perform each step of the decoding method according to claim 7 is stored.

**Patentansprüche**

1. Codierungsverfahren, das Folgendes umfasst:

einen Codierungsbetriebsart-Auswahlschritt, in dem eine zweite Codierungsbetriebsart ausgewählt wird, wenn ein Bewertungswert ein zweiter Bezugswert oder darunter ist, Auswählen einer ersten, von der zweiten Codierungsbetriebsart unterschiedlichen, Codierungsbetriebsart, wenn die zweite Codierungsbetriebsart nicht ausgewählt ist, und Erzeugen von Betriebsartinformationen, die eine ausgewählte Codierungsbetriebsart darstellen, wobei der Bewertungswert der Anzahl von Abtastungen entspricht, die Werten unterhalb eines ersten Bezugswerts aus einer vorgegebenen Anzahl von Eingabeabtastungen entspricht, und die zweite Codierungsbetriebsart eine Betriebsart ist, in der ein Normalisierungswert quantisiert wird, der ein repräsentativer Wert der vorgegebenen Anzahl von Abtastungen ist, um einen quantisierten Normalisierungswert und einen Normalisierungswert-Quantisierungsindex zu erlangen, der dem quantisierten Normalisierungswert entspricht, ein Differenzwert für jede Abtastung, der durch Subtrahieren eines Werts, der dem quantisierten Norrrialisierungswert entspricht, von einem Wert erlangt wird, der der Größe einer Abtastung entspricht, als ein Quantisierungskandidat eingestellt wird, der der Abtastung entspricht, wenn der Differenzwert positiv ist und die Abtastung positiv ist, das Vorzeichen des Differenzwerts umgekehrt wird, und das Ergebnis auf den Quantisierungskandidaten eingestellt wird, der der Abtastung entspricht, wenn der Differenzwert positiv und die Abtastung negativ ist, und eine Vielzahl von Quantisierungskandidaten gemeinsam vektorquantisiert werden, um einen Vektorquantisierungsindex zu erlangen; und

einen Codierungsschritt, in dem die vorgegebene Anzahl von Abtastungen anhand der ersten Codierungsbetriebsart oder der zweiten Codierungsbetriebsart codiert wird, die im Codierungsbetriebsart-Auswahlschritt ausgewählt wird,

**dadurch gekennzeichnet, dass**:

die erste Codierungsbetriebsart eine Betriebsart ist, in der der Vektorquantisierungsindex durch Vektorquantisierung gemäß einer Vektorquantisierungsbetriebsart erlangt wird, in der quantisierte Werte, die nicht null sind, nur für einige der vorgegebenen Anzahl von Abtastungen erlangt werden, und quantisierte Werte, die null sind, von den verbleibenden Abtastungen erlangt werden; und

die zweite Codierungsbetriebsart einen Vorgang beinhaltet, in dem Null als der Quantisierungskandidat eingestellt wird, der jeder der Abtastungen entspricht, wenn der Differenzwert nicht positiv ist.

**2.** Codierungsverfahren nach Anspruch 1, wobei der Bewertungswert ein gewichteter Additionswert aus einem zu einem früheren Zeitpunkt berechneten Bewertungswert und der Anzahl von Abtastungen ist, die Werten unterhalb des ersten Bezugswerts entsprechen.

**3.** Codierungsverfahren nach Anspruch 1 oder 2, wobei der zweite Bezugswert kleiner ist, wenn eine zuvor vorgegebene Anzahl von Abtastungen anhand der ersten Codierungsbetriebsart codiert wird, als wenn die zuvor vorgegebene Anzahl von Abtastungen anhand der zweiten Codierungsbetriebsart codiert wird.

**4.** Codierungsverfahren nach Anspruch 3, wobei der Bewertungswert ein Wert ist, der der Anzahl von Abtastungen entspricht, die Abtastungen enthalten, die ein auf auditiven Wahrnehmungseigenschaften beruhendes Kriterium erfüllen und die Werten unterhalb des ersten Bezugswerts aus der vorgegebenen Anzahl von Abtastungen entsprechen.

**5.** Codierungsverfahren nach Anspruch 1 oder 2, wobei der Bewertungswert ein Wert ist, der der Anzahl von Abtastungen entspricht, die Abtastungen enthalten, die ein auf auditiven Wahrnehmungseigenschaften beruhendes Kriterium erfüllen und die Werten unterhalb des ersten Bezugswerts aus der vorgegebenen Anzahl von Abtastungen entsprechen.

**6.** Codierungsverfahren nach Anspruch 1, wobei die erste Codierungsbetriebsart eine Betriebsart ist, in der ein Normalisierungswert, der repräsentativ für die vorgegebene Anzahl von Abtastungen ist, ferner quantisiert wird, um einen quantisierten Normalisierungswert und einen Normalisierungswert-Quantisierungsindex zu erlangen, der dem quantisierten Normalisierungswert entspricht, und die quantisierten Werte, die nicht null sind, nur für einige der vorgegebenen Anzahl von normalisierten Abtastungen erlangt werden, die durch Normalisieren der vorgegebenen Anzahl von Abtastungen anhand des quantisierten Normalisierungswerts erlangt werden.

**7.** Codierungsverfahren, das Folgendes umfasst:

einen Schaltschritt, in dem eine zweite Decodierungsbetriebsart ausgewählt wird, wenn Eingabe-Betriebsartinformationen einen zweiten Wert aufweisen, und Auswählen einer ersten, von der zweiten Decodierungsbetriebsart unterschiedlichen, Decodierungsbetriebsart, wenn die Betriebsartinformationen einen ersten Wert aufweisen, wobei die zweite Decodierungsbetriebsart eine Betriebsart ist, in der ein decodierter Normalisierungswert erlangt wird, der einem Eingabe-Normalisierungswert-Quantisierungsindex entspricht, eine Vielzahl von Werten, die einem Eingabe-Vektorquantisierungsindex entsprechen, als decodierte Werte erlangt werden, ein Wert mit einer Größe, die einem neu berechneten Normalisierungswert entspricht, der einen Wert annimmt, der mit zunehmender Summe der absoluten Werte einer vorgegebenen Anzahl der decodierten Werte abnimmt, als decodiertes Signal erlangt wird, wenn der decodierte Wert null ist, eine lineare Summe des decodierten Werts und des decodierten Normalisierungswerts als decodiertes Signal erlangt wird, wenn der decodierte Wert positiv ist, und ein Vorzeichen der linearen Summe des absoluten Werts des decodierten Werts und des decodierten Normalisierungswerts umgekehrt wird, und das Ergebnis als decodiertes Signal eingestellt wird, wenn der decodierte Wert negativ ist; und

ein Decodierungsschritt, in dem ein Decodierungsvorgang in der ersten Decodierungsbetriebsart oder der zweiten Decodierungsbetriebsart ausgeführt wird, der im Schaltschritt ausgewählt wird,

**dadurch gekennzeichnet, dass**:

die erste Decodierungsbetriebsart eine Betriebsart ist, in der der Normalisierungswert-Quantisierungsindex decodiert wird, um den decodierten Normalisierungswert zu erzeugen, der Vektorquantisierungsindex decodiert wird, um eine Abtastfolge zu erzeugen, und eine decodierte Signalabtastfolge erlangt wird, indem die Abtastungen der Abtastfolge mit dem decodierten Normalisierungswert multipliziert werden.

8. Eine Decodierungsvorrichtung (11), die Folgendes umfasst:

einen Codierungsbetriebsartenwähler (114), der eine zweite Codierungsbetriebsart auswählt, wenn ein Bewertungswert ein zweiter Bezugswert oder darunter ist, eine erste, von der zweiten Codierungsbetriebsart unterschiedliche, Codierungsbetriebsart auswählt, wenn die zweite Codierungsbetriebsart nicht ausgewählt ist, und Betriebsartinformationen erzeugt, die eine ausgewählte Codierungsbetriebsart darstellen, wobei der Bewertungswert der Anzahl von Abtastungen entspricht, die Werten unterhalb eines ersten Bezugswerts aus einer vorgegebenen Anzahl von Eingabeabtastungen entspricht, und die zweite Codierungsbetriebsart eine Betriebsart ist, in der ein Normalisierungswert quantisiert wird, der ein repräsentativer Wert der vorgegebenen Anzahl von Abtastungen ist, um einen quantisierten Normalisierungswert und einen Normalisierungswert-Quantisierungsindex zu erlangen, der dem quantisierten Normalisierungswert entspricht, ein Differenzwert für jede Abtastung, der durch Subtrahieren eines Werts, der dem quantisierten Normalisierungswert entspricht, von einem Wert erlangt wird, der der Größe einer Abtastung entspricht, als ein Quantisierungskandidat eingestellt wird, der der Abtastung entspricht, wenn der Differenzwert positiv ist und die Abtastung positiv ist, das Vorzeichen des Differenzwerts umgekehrt wird, und das Ergebnis auf den Quantisierungskandidaten eingestellt wird, der der Abtastung entspricht, wenn der Differenzwert positiv und die Abtastung negativ ist, und eine Vielzahl von Quantisierungskandidaten gemeinsam vektorquantisiert werden, um einen Vektorquantisierungsindex zu erlangen; und
einen Codierer (117, 118) der die vorgegebene Anzahl von Abtastungen anhand der ersten Codierungsbetriebsart oder der zweiten Codierungsbetriebsart codiert, die vom Codierungsbetriebsartenwähler (114) ausgewählt wird,
**dadurch gekennzeichnet, dass**
die erste Codierungsbetriebsart eine Betriebsart ist, in der der Vektorquantisierungsindex durch Vektorquantisierung gemäß einer Vektorquantisierungsbetriebsart erlangt wird, in der quantisierte Werte, die nicht null sind, nur für einige der vorgegebenen Anzahl von Abtastungen erlangt werden, und quantisierte Werte, die null sind, von den verbleibenden Abtastungen erlangt werden; und
die zweite Codierungsbetriebsart einen Vorgang beinhaltet, in dem Null als der Quantisierungskandidat eingestellt wird, der jeder der Abtastungen entspricht, wenn der Differenzwert nicht positiv ist.

9. Codierungsvorrichtung nach Anspruch 8, wobei der Bewertungswert ein gewichteter Additionswert aus einem zu einem früheren Zeitpunkt berechneten Bewertungswert und der Anzahl von Abtastungen ist, die Werten unterhalb des ersten Bezugswerts entsprechen.

10. Codierungsvorrichtung nach Anspruch 8 oder 9, wobei der zweite Bezugswert kleiner ist, wenn eine zuvor vorgegebene Anzahl von Abtastungen anhand der ersten Codierungsbetriebsart codiert wird, als wenn die zuvor vorgegebene Anzahl von Abtastungen anhand der zweiten Codierungsbetriebsart codiert wird.

11. Codierungsvorrichtung nach Anspruch 10, wobei der Bewertungswert ein Wert ist, der der Anzahl von Abtastungen entspricht, die Abtastungen enthalten, die ein auf auditiven Wahrnehmungseigenschaften beruhendes Kriterium erfüllen, und die Werten unterhalb des ersten Bezugswerts aus der vorgegebenen Anzahl von Abtastungen entsprechen.

12. Codierungsvorrichtung nach Anspruch 8 oder 9, wobei der Bewertungswert ein Wert ist, der der Anzahl von Abtastungen entspricht, die Abtastungen enthalten, die ein auf auditiven Wahrnehmungseigenschaften beruhendes Kriterium erfüllen, und die Werten unterhalb des ersten Bezugswerts aus der vorgegebenen Anzahl von Abtastungen entsprechen.

13. Codierungsvorrichtung nach Anspruch 8, wobei die erste Codierungsbetriebsart eine Betriebsart ist, in der ein Normalisierungswert, der repräsentativ für die vorgegebene Anzahl von Abtastungen ist, ferner quantisiert wird, um einen quantisierten Normalisierungswert und einen Normalisierungswert-Quantisierungsindex zu erlangen, der dem quantisierten Normalisierungswert entspricht, und die quantisierten Werte, die nicht null sind, nur für einige der vorgegebenen Anzahl normalisierter Abtastungen erlangt werden, die durch Normalisieren der vorgegebenen Anzahl von Abtastungen anhand des quantisierten Normalisierungswerts erlangt werden.

**14.** Decodierungsvorrichtung (12), die Folgendes umfasst:

eine Schalteinheit (125, 126), die eine zweite Decodierungsbetriebsart auswählt, wenn Betriebsartinformationen einen zweiten Wert aufweisen, und eine erste, von der zweiten Decodierungsbetriebsart unterschiedliche, Decodierungsbetriebsart auswählt, wenn die Betriebsartinformationen einen ersten Wert aufweisen, wobei die zweite Decodierungsbetriebsart eine Betriebsart ist, in der ein decodierter Normalisierungswert erlangt wird, der einem Eingabe-Normalisierungswert-Quantisierungsindex entspricht, eine Vielzahl von Werten, die einem Eingabe-Vektorquantisierungsindex entsprechen, als decodierte Werte erlangt werden, ein Wert mit einer Größe, die einem neu berechneten Normalisierungswert entspricht, der einen Wert annimmt, der mit zunehmender Summe der absoluten Werte einer vorgegebenen Anzahl der decodierten Werte abnimmt, als decodiertes Signal erlangt wird, wenn der decodierte Wert null ist, eine lineare Summe des decodierten Werts und des decodierten Normalisierungswerts als decodiertes Signal erlangt wird, wenn der decodierte Wert positiv ist, und ein Vorzeichen der linearen Summe des absoluten Werts des decodierten Werts und des decodierten Normalisierungswerts umgekehrt wird, und das Ergebnis als decodiertes Signal eingestellt wird, wenn der decodierte Wert negativ ist; und
einen Decodierer (123, 127, 128) zum Ausführen eines Decodierungsvorgangs in der ersten Decodierungsbetriebsart oder der zweiten Decodierungsbetriebsart, die von der Schalteinheit ausgewählt wird,
**dadurch gekennzeichnet, dass**:

die erste Decodierungsbetriebsart eine Betriebsart ist, in der der Normalisierungswert-Quantisierungsindex decodiert wird, um den decodierten Normalisierungswert zu erzeugen, der Vektorquantisierungsindex decodiert wird, um eine Abtastfolge zu erzeugen, und eine decodierte Signalabtastfolge erlangt wird, indem die Abtastungen der Abtastfolge mit dem decodierten Normalisierungswert multipliziert werden.

**15.** Programm, das einen Computer veranlasst, jeden Schritt des Codierungsverfahrens gemäß Anspruch 1 auszuführen.

**16.** Programm, das einen Computer veranlasst, jeden Schritt des Decodierungsverfahrens gemäß Anspruch 7 auszuführen.

**17.** Computerlesbares Aufnahmemedium, auf dem ein Programm gespeichert ist, das einen Computer dazu veranlasst, jeden Schritt des Codierungsverfahrens gemäß Anspruch 1 auszuführen.

**18.** Computerlesbares Aufnahmemedium, auf dem ein Programm gespeichert ist, das einen Computer veranlasst, jeden Schritt des Decodierungsverfahrens gemäß Anspruch 7 auszuführen.


**Revendications**

**1.** Procédé de codage comprenant :

une étape de sélection du mode de codage consistant à sélectionner un second mode de codage lorsqu'une valeur d'évaluation est égale ou inférieure à une seconde valeur de référence, sélectionner un premier mode de codage, différent du second mode de codage, lorsque le second mode de codage n'est pas sélectionné, et à produire des informations de mode qui représentent un mode de codage sélectionné, dans lequel la valeur d'évaluation correspond au nombre d'échantillons qui, parmi un nombre prédéterminé d'échantillons d'entrée, correspondent à des valeurs inférieures à une première valeur de référence, et le second mode de codage est un mode dans lequel une valeur de normalisation qui est une valeur représentative du nombre prédéterminé d'échantillons est quantifiée pour donner une valeur de normalisation quantifiée et un index de quantification de la valeur de normalisation qui correspond à la valeur de normalisation quantifiée, une valeur de différence qui est obtenue pour chaque échantillon en soustrayant une valeur correspondant à la valeur de normalisation quantifiée d'une valeur correspondant à l'amplitude d'un échantillon est traitée comme valeur candidate de quantification correspondant à l'échantillon lorsque la valeur de différence est positive et l'échantillon est positif, le signe de la valeur de différence est inversé et le résultat est traité comme valeur candidate de quantification correspondant à l'échantillon lorsque la valeur de différence est positive et l'échantillon négatif, et une pluralité de valeurs candidates de quantification subissent conjointement une quantification vectorielle pour donner un indice de quantification vectorielle ; et
une étape de codage, consistant à coder le nombre prédéterminé d'échantillons à l'aide du premier mode de codage ou du second mode de codage, sélectionné dans l'étape de sélection du mode de codage ;
**caractérisé en ce que** :

le premier mode de codage est un mode dans lequel l'indice de quantification vectorielle est obtenu par une quantification vectorielle à l'aide d'un mode de quantification vectorielle dans lequel des valeurs quantifiées non nulles ne sont obtenues que pour certains échantillons parmi le nombre prédéterminé d'échantillons et des valeurs quantifiées nulles sont obtenues pour les autres échantillons ; et

le second mode de codage comprend un processus consistant à prendre zéro comme valeur candidate de quantification pour chaque échantillon lorsque la valeur de différence n'est pas positive.

2.  Procédé de codage selon la revendication 1, dans lequel la valeur d'évaluation est une valeur obtenue par addition pondérée d'une valeur d'évaluation calculée antérieurement et du nombre des échantillons qui correspondent à des valeurs inférieures à la première valeur de référence.

3.  Procédé de codage selon la revendication 1 ou 2, dans lequel la seconde valeur de référence, lorsqu'un nombre prédéterminé précédent d'échantillons a été codé à l'aide du premier mode de codage, est inférieure à la valeur obtenue lorsque le nombre prédéterminé précédent d'échantillons a été codé à l'aide du second mode de codage.

4.  Procédé de codage selon la revendication 3, dans lequel la valeur d'évaluation est une valeur correspondant au nombre d'échantillons qui comprend des échantillons qui satisfont un critère fondé sur des caractéristiques perceptives auditives et qui correspondent à des valeurs inférieures à la première valeur de référence parmi le nombre prédéterminé d'échantillons.

5.  Procédé de codage selon la revendication 1 ou 2, dans lequel la valeur d'évaluation est une valeur correspondant au nombre d'échantillons qui comprend des échantillons qui satisfont un critère fondé sur des caractéristiques perceptives auditives et qui correspondent à des valeurs inférieures à la première valeur de référence parmi le nombre prédéterminé d'échantillons.

6.  Procédé de codage selon la revendication 1, dans lequel le premier mode de codage est un mode dans lequel une valeur de normalisation qui est représentative du nombre prédéterminé d'échantillons est en outre quantifiée pour donner une valeur de normalisation quantifiée et un indice de quantification de valeur de normalisation correspondant à la valeur de normalisation quantifiée, et les valeurs quantifiées non nulles ne sont obtenues que pour certains échantillons parmi le nombre prédéterminé d'échantillons normalisés qui sont obtenus par une normalisation du nombre prédéterminé d'échantillons à l'aide de la valeur de normalisation quantifiée.

7.  Procédé de décodage comprenant :

une étape de commutation consistant à sélectionner un second mode de décodage lorsque des informations de mode d'entrée ont une seconde valeur, et à sélectionner un premier mode de décodage différent du second mode de décodage lorsque les informations de mode ont une première valeur, dans lequel le second mode de décodage est un mode dans lequel une valeur de normalisation décodée correspondant à un indice de quantification de valeur de normalisation d'entrée est obtenue, une pluralité de valeurs correspondant à un index de quantification vectorielle d'entrée est obtenue sous forme de valeurs décodées, une valeur ayant une amplitude correspondant à une valeur de normalisation recalculée qui prend une valeur qui décroît lorsque croît la somme des valeurs absolues d'un nombre prédéterminé des valeurs décodées est obtenue comme signal décodé lorsque la valeur décodée est nulle, une somme linéaire de la valeur décodée et de la valeur de normalisation décodée est obtenue comme signal décodé lorsque la valeur décodée est positive, et un signe de la somme linéaire de la valeur absolue de la valeur décodée et de la valeur de normalisation décodée est inversé et le résultat est pris comme signal décodé lorsque la valeur décodée est négative ; et

une étape de décodage consistant à effectuer un processus de décodage dans le premier mode de décodage ou dans le second mode de décodage, qui est sélectionné dans l'étape de commutation ;
**caractérisé en ce que** :

le premier mode de décodage est un mode dans lequel l'index de quantification de la valeur de normalisation est décodé pour produire la valeur de normalisation décodée, l'indice de quantification vectorielle est décodé pour produire une séquence d'échantillons, et une séquence d'échantillons du signal décodé est obtenue en multipliant les échantillons de la séquence d'échantillons par la valeur de normalisation décodée.

**8.** Dispositif de codage (11) comprenant :

un sélecteur de mode de codage (114) qui sélectionne un second mode de codage lorsqu'une valeur d'évaluation est égale ou inférieure à une seconde valeur de référence, qui sélectionne un premier mode de codage, différent du second mode de codage, lorsque le second mode de codage n'est pas sélectionné, et qui produit des informations de mode qui représentent un mode de codage sélectionné, dans lequel la valeur d'évaluation correspond au nombre d'échantillons qui, parmi un nombre prédéterminé d'échantillons d'entrée, correspondent à des valeurs inférieures à une première valeur de référence, et le second mode de codage est un mode dans lequel une valeur de normalisation qui est une valeur représentative du nombre prédéterminé d'échantillons est quantifiée pour donner une valeur de normalisation quantifiée et un index de quantification de la valeur de normalisation qui correspond à la valeur de normalisation quantifiée, une valeur de différence qui est obtenue pour chaque échantillon en soustrayant une valeur correspondant à la valeur de normalisation quantifiée d'une valeur correspondant à l'amplitude d'un échantillon est traitée comme valeur candidate de quantification correspondant à l'échantillon lorsque la valeur de différence est positive et l'échantillon est positif, le signe de la valeur de différence est inversé et le résultat est traité comme valeur candidate de quantification correspondant à l'échantillon lorsque la valeur de différence est positive et l'échantillon négatif, et une pluralité de valeurs candidates de quantification subissent conjointement une quantification vectorielle pour donner un indice de quantification vectorielle ; et
un codeur (117, 118) qui code le nombre prédéterminé d'échantillons à l'aide du premier mode de codage ou du second mode de codage, sélectionné par le sélecteur de mode de codage (114) ;
**caractérisé en ce que** :

le premier mode de codage est un mode dans lequel l'indice de quantification vectorielle est obtenu par une quantification vectorielle à l'aide d'un mode de quantification vectorielle dans lequel des valeurs quantifiées non nulles ne sont obtenues que pour certains échantillons parmi le nombre prédéterminé d'échantillons et des valeurs quantifiées nulles sont obtenues pour les autres échantillons ; et
le second mode de codage comprend un processus consistant à prendre zéro comme valeur candidate de quantification pour chaque échantillon lorsque la valeur de différence n'est pas positive.

**9.** Dispositif de codage selon la revendication 8, dans lequel la valeur d'évaluation est une valeur obtenue par addition pondérée d'une valeur d'évaluation calculée antérieurement et du nombre des échantillons qui correspondent à des valeurs inférieures à la première valeur de référence.

**10.** Dispositif de codage selon la revendication 8 ou 9, dans lequel la seconde valeur de référence, lorsqu'un nombre prédéterminé précédent d'échantillons a été codé à l'aide du premier mode de codage, est inférieure à la valeur obtenue lorsque le nombre prédéterminé précédent d'échantillons a été codé à l'aide du second mode de codage.

**11.** Dispositif de codage selon la revendication 10, dans lequel la valeur d'évaluation est une valeur correspondant au nombre d'échantillons qui comprend des échantillons qui satisfont un critère fondé sur des caractéristiques perceptives auditives et qui correspond à des valeurs inférieures à la première valeur de référence parmi le nombre prédéterminé d'échantillons.

**12.** Dispositif de codage selon la revendication 8 ou 9, dans lequel la valeur d'évaluation est une valeur correspondant au nombre d'échantillons qui comprend des échantillons qui satisfont un critère fondé sur des caractéristiques perceptives auditives et qui correspondent à des valeurs inférieures à la première valeur de référence parmi le nombre prédéterminé d'échantillons.

**13.** Dispositif de codage selon la revendication 8, dans lequel le premier mode de codage est un mode dans lequel une valeur de normalisation qui est représentative du nombre prédéterminé d'échantillons est en outre quantifiée pour donner une valeur de normalisation quantifiée et un indice de quantification de valeur de normalisation correspondant à la valeur de normalisation quantifiée, et les valeurs quantifiées non nulles ne sont obtenues que pour certains échantillons parmi le nombre prédéterminé d'échantillons normalisés qui sont obtenus par une normalisation du nombre prédéterminé d'échantillons à l'aide de la valeur de normalisation quantifiée.

**14.** Dispositif de décodage (12) comprenant :

une unité de commutation (125, 126) qui sélectionne un second mode de décodage lorsque des informations de mode d'entrée ont une seconde valeur et qui sélectionne un premier mode de décodage différent du second mode de décodage lorsque les informations de mode ont une première valeur, où le second mode de décodage est un mode dans lequel une valeur de normalisation décodée correspondant à un indice de quantification de valeur de normalisation d'entrée est obtenue, une pluralité de valeurs correspondant à un index de quantification vectorielle d'entrée est obtenue sous forme de valeurs décodées, une valeur ayant une amplitude correspondant à une valeur de normalisation recalculée qui prend une valeur qui décroît lorsque croît la somme des valeurs absolues d'un nombre prédéterminé des valeurs décodées est obtenue comme signal décodé lorsque la valeur décodée est nulle, une somme linéaire de la valeur décodée et de la valeur de normalisation décodée est obtenue comme signal décodé lorsque la valeur décodée est positive, et un signe de la somme linéaire de la valeur absolue de la valeur décodée et de la valeur de normalisation décodée est inversé et le résultat est pris comme signal décodé lorsque la valeur décodée est négative ; et

un décodeur (123, 127, 128) qui effectue un processus de décodage dans le premier mode de décodage ou dans le second mode de décodage, qui est sélectionné par l'unité de commutation ;

**caractérisé en ce que** :

le premier mode de décodage est un mode dans lequel l'index de quantification de la valeur de normalisation est décodé pour produire la valeur de normalisation décodée, l'indice de quantification vectorielle est décodé pour produire une séquence d'échantillons, et une séquence d'échantillons du signal décodé est obtenue en multipliant les échantillons de la séquence d'échantillons par la valeur de normalisation décodée.

15. Programme destiné à commander à un ordinateur d'exécuter chacune des étapes du procédé de codage selon la revendication 1.

16. Programme destiné à commander à un ordinateur d'exécuter chacune des étapes du procédé de décodage selon la revendication 7.

17. Support d'enregistrement lisible par ordinateur, sur lequel est enregistré un programme destiné à commander à un ordinateur d'exécuter chacune des étapes du procédé de codage selon la revendication 1.

18. Support d'enregistrement lisible par ordinateur, sur lequel est enregistré un programme destiné à commander à un ordinateur d'exécuter chacune des étapes du procédé de décodage selon la revendication 7.

FIG. 1

FIG. 2

EP 2 573 942 B1

# FIG. 3

# FIG. 4

```
        ┌─────────────────────┐
        │   START ENCODING    │
        └─────────────────────┘
                   │
                   ▼
    ┌───────────────────────────────┐
    │  CALCULATE NORMALIZATION      │  ～ E1
    │  VALUE            $_rX_0$      │
    └───────────────────────────────┘
                   │
                   ▼
    ┌───────────────────────────────┐
    │  CALCULATE QUANTIZED          │  ～ E2
    │  NORMALIZATION VALUE  $_r\overline{X}$  │
    └───────────────────────────────┘
                   │
                   ▼
        ┌─────────────────────┐  E3
        │  SELECT ENCODING    │  ～
        │       MODE          │
        └─────────────────────┘
   E4              │
    ～             ▼
            ◇─────────────◇        1
            ＜   mode?    ＞───────────────────┐
            ◇─────────────◇                    │
                   │ 0                         │
                   ▼                           ▼
        ┌──────────────┐  E5       ┌──────────────┐  E6
        │    FIRST     │  ～       │    SECOND    │  ～
        │  ENCODING    │          │  ENCODING    │
        │    MODE      │          │    MODE      │
        └──────────────┘          └──────────────┘
                   │                           │
                   ▼◄──────────────────────────┘
        ┌─────────────────────┐
        │    END ENCODING     │
        └─────────────────────┘
```

START STEP E3

E314' — s=0

E31 — k=0 m=0

E32 — k<L — No / Yes

E33 — $\tilde{X}(k) = X(k)/_\tau \overline{X}$

E34 — $\left|\tilde{X}(k)\right| < Th$ — No / Yes

E36 — k++

E35 — m++

E37 — $\overline{\overline{m}} = \varepsilon \cdot m + \sigma \cdot \overline{\overline{m'}}$

E38 — $t == T_{MIN}$ — No / Yes

E311' — s=1

E39 — $\overline{\overline{m}} > t$ — No / Yes

E310 — s=0

E311 — s=1 t=$T_{MAX}$

E311'' — t=$T_{MAX}$

E312 — $\overline{\overline{m}} < t$ — No / Yes

E313 — s=1

E314 — s=0 t=$T_{MIN}$

E314'' — t=$T_{MIN}$

END STEP E3

FIG. 5

## FIG. 6

START STEP E3

E31
$k=0$
$m=0$

E32
$k<L$ — No

Yes — E33
$\tilde{X}(k) = X(k)/_\tau \overline{X}$

E34
$\left|\tilde{X}(k)\right| < Th$

No → E36
$k++$

Yes → E35
$m++$

E37
$\overline{\overline{m}} = \varepsilon \cdot \overline{\overline{m}} + \sigma \cdot \overline{\overline{m'}}$

E321
$\overline{\overline{m}} > t$ — No

Yes → E322
$s=0$
$t=T_{MIN}$

E323
$s=1$
$t=T_{MAX}$

END STEP E3

EP 2 573 942 B1

FIG. 7

START STEP E3

$s=0$  E314'

$i=0 \quad m=0$  E330

E334  $i$++  E331

$i<G$  No

Yes  E332

$ord(i)<P$  No

Yes  E333

$h=0$

E339  $h$++

E335

$h<C_0$  No

Yes  E336

$\tilde{X}(i \cdot C_0 + h) = X(i \cdot C_0 + h)/_i\overline{X}$

E337

$\left|\tilde{X}(i \cdot C_0 + h)\right| < Th$  No

Yes

E338  $m$++

E37

$\overline{\overline{m}} = \varepsilon \cdot \overline{\overline{m}} + \sigma \cdot \overline{\overline{m}}'$

$t == T_{MIN}$  No

E38  Yes

$s=1$

E39  $\overline{\overline{m}} > t$  No  E311  E312  $\overline{\overline{m}} < t$  No  E314

Yes  Yes

$s=0$  $s=1$ $t=T_{MAX}$  $t=T_{MAX}$  $s=1$  $s=0$ $t=T_{MIN}$  $t=T_{MIN}$

E310  E311''  E313  E314''

END STEP E3

EP 2 573 942 B1

39

FIG. 8

START STEP E3

$i=0 \quad m=0$ — E330

E334

$i{+}{+}$

E331

$i<G$ — No — Yes

E332

$ord(i)<P$ — No — Yes

$h=0$ — E333

E339

$h{+}{+}$

E335

$h<C_0$ — No — Yes

E336

$$\widetilde{X}(i \cdot C_0 + h) = X(i \cdot C_0 + h)/{_i}\overline{X}$$

E337

$$\left|\widetilde{X}(i \cdot C_0 + h)\right| < Th$$ — No — Yes

E338

$m{+}{+}$

E37

$$\overline{\overline{m}} = \varepsilon \cdot \overline{m} + \sigma \cdot \overline{\overline{m}}'$$

E321

$$\overline{\overline{m}} > t$$ — No — Yes

E322

$s=0$
$t=T_{MIN}$

E323

$s=1$
$t=T_{MAX}$

END STEP E3

EP 2 573 942 B1

FIG. 9

START STEP E3

E314' — s=0

E330 — i=0 m=0

E341 — i<P

E342 — b=o(i)

E333 — h=0

E335 — h<C_0

E346 — $\tilde{X}(b \cdot C_0 + h) = X(b \cdot C_0 + h)/_b \overline{X}$

E347 — $|\tilde{X}(b \cdot C_0 + h)| < Th$

E338 — m++

E339 — h++

E334 — i++

E37 — $m = \varepsilon \cdot m + \sigma \cdot m'$

E38 — $t == T_{MIN}$

s=1

E39 — $m > t$

E310 — s=0

E311 — s=1 t=T_{MAX}

E311" — t=T_{MAX}

E312 — $m < t$

E313 — s=1

E314 — s=0 t=T_{MIN}

E314" — t=T_{MIN}

END STEP E3

# FIG. 10

# FIG. 11

```
        ┌─────────────────────┐
        │   START STEP E6      │
        └─────────────────────┘
                  │
                  ▼                          E61
   ┌ ─ ─ ─ ─ ─ ─ ─ ─ ─ ─ ─ ─ ─ ─ ─ ─ ┐
   │   CALCULATE QUANTIZATION-CANDIDATE  │
   │      NORMALIZATION VALUE $_\tau \bar{E}$      │
   └ ─ ─ ─ ─ ─ ─ ─ ─ ─ ─ ─ ─ ─ ─ ─ ─ ┘
                  │
                  ▼                  E62
        ┌─────────────────────┐
        │ CALCULATE QUANTIZATION-│
        │   CANDIDATE E(k)      │
        └─────────────────────┘
                  │
                  ▼                  E63
        ┌─────────────────────┐
        │      VECTOR          │
        │   QUANTIZATION       │
        └─────────────────────┘
                  │
                  ▼                       E64
   ┌ ─ ─ ─ ─ ─ ─ ─ ─ ─ ─ ─ ─ ─ ─ ┐
   │   CALCULATE NUMBER U OF       │
   │     UNUSED BITS AND           │
   │  QUANTIZATION VALUE $\hat{E}(k)'$  │
   └ ─ ─ ─ ─ ─ ─ ─ ─ ─ ─ ─ ─ ─ ─ ┘
                  │
                  ▼                E65
   ┌ ─ ─ ─ ─ ─ ─ ─ ─ ─ ─ ┐
   │    PLACE SIGN          │
   │    INFORMATION         │
   └ ─ ─ ─ ─ ─ ─ ─ ─ ─ ─ ┘
                  │
                  ▼
        ┌─────────────────────┐
        │    END STEP E6       │
        └─────────────────────┘
```

**FIG. 12**

EP 2 573 942 B1

```
                    ┌─────────────────────┐
                    │   START STEP E62     │
                    └──────────┬──────────┘
                               │
                          ┌────┴────┐  E621
                          │  k=0    │
                          └────┬────┘
                               │  E622
                          ╱────┴────╲        No
                         ╱  k < C₀   ╲──────────────────────────────────┐
                         ╲           ╱                                   │
                          ╲─────────╱                                    │
                               │ Yes                                     │
                          ┌────┴──────────────┐  E623                    │
                          │ E(k)'=|X(k)|-C₁·ₜX̄ │                          │
                          └────┬──────────────┘                          │
                               │ Yes                                     │
                               │  E624                                   │
                          ╱────┴────╲      No                    E625'   │
                         ╱ E(k)'≧0   ╲──────────────┐      ┌ ─ ─ ─ ─ ─┐ │
                         ╲           ╱               │      ┆ E(k)=0   ┆ │
                          ╲─────────╱                ▼      └ ─ ─ ─ ─ ─┘ │
                               │ Yes          ┌──────────┐               │
          E626                 │◄─────────────│ E(k)'=0  │               │
       ╱────┴────╲      No     │              └──────────┘               │
      ╱  X(k)<0   ╲────────┐   │                 E625                    │
      ╲           ╱        │   │                                         │
       ╲─────────╱         │   │                                         │
            │ Yes          │   │                                         │
            │  E628        │  E627                                       │
      ┌─────┴─────┐   ┌────┴──────┐                                      │
      │E(k)=-E(k)'│   │E(k)=E(k)' │                                      │
      └─────┬─────┘   └────┬──────┘                                      │
            │              │                                             │
            └──────┬───────┘                                             │
                   │◄ ─ ─ ─ ─ ─ ─ ─ ─ ─ ─ ─ ─ ─ ─ ─ ─ ─ ─ ─ ─ ─ ─ ─ ─ ─┘
                   │  E629
              ┌────┴────┐
              │  k++    │
              └─────────┘
```

$$E(k)' = |X(k)| - C_{1\cdot\tau}\overline{X}$$

┌─────────────────────┐
│   END STEP E62       │
└─────────────────────┘

FIG. 13

START STEP E65

k=0
m=0    E651

E652
$k < C_0$ — No

Yes    E653

$m < U$ — No → k++    E655

Yes    E654

$\hat{E}(k)' == 0$ — No

Yes    E656

$X(k) < 0$ — No → b(m)=1    E658

Yes

b(m)=0    E657

m++    E659

UPDATE UNUSED BIT AREA
AND SET "U – m" AS NEW U    E6510

END STEP E65

EP 2 573 942 B1

# FIG. 14

START DECODING

D1

ACQUIRE DECODED
NORMALIZATION VALUE $\bar{X}$

D2

mode?

1

0

D3

PERFORM
FIRST ENCODING

D4

PERFORM
SECOND ENCODING

END DECODING

# FIG. 15

```
          ┌─────────────────────┐
          │    START STEP D4     │
          └─────────────────────┘
                     │
                     ▼
  ┌ ─ ─ ─ ─ ─ ─ ─ ─ ─ ─ ─ ─ ─ ─ ─ ─ ┐   D41
  │  CALCULATE DECODING-CANDIDATE    │
  │                                  │
  │   NORMALIZATION VALUE $_\tau \overline{E}$   │
  └ ─ ─ ─ ─ ─ ─ ─ ─ ─ ─ ─ ─ ─ ─ ─ ─ ┘
                     │
                     ▼
      ┌──────────────────────┐   D42
      │    OBTAIN DECODED     │
      │                       │
      │   VALUE  $\hat{E}(k)$   │
      └──────────────────────┘
                     │
                     ▼
      ┌ ─ ─ ─ ─ ─ ─ ─ ─ ─ ─ ┐   D42'
      │  CALCULATE NUMBER U  │
      │    OF UNUSED BITS    │
      └ ─ ─ ─ ─ ─ ─ ─ ─ ─ ─ ┘
                     │
                     ▼
    ┌────────────────────────┐   D43, D43'
    │ CALCULATE RECALCULATED  │
    │ NORMALIZATION VALUE $_\tau \overline{X}$ │
    └────────────────────────┘
                     │
                     ▼
       ┌──────────────────┐   D44, D44'
       │  CALCULATE  $\hat{x}$  │
       └──────────────────┘
                     │
                     ▼
  ┌ ─ ─ ─ ─ ─ ─ ─ ─ ─ ─ ─ ─ ─ ─ ┐   D45
  │      SMOOTHING OF            │
  │  FREQUENCY COMPONENT         │
  └ ─ ─ ─ ─ ─ ─ ─ ─ ─ ─ ─ ─ ─ ─ ┘
                     │
                     ▼
          ┌─────────────────────┐
          │     END STEP D4      │
          └─────────────────────┘
```

FIG. 16

# FIG. 17

START STEP D44 (D44')

$k = 0$ — D441

$k < C_0$ — D442 → No

Yes

$\hat{E}(k) == 0$ — D443 → No → $\hat{E}(k) < 0$ — D445 → No

Yes

$\hat{X}(k) = C_{3 \cdot \tau} \overline{\overline{X}} \cdot \mathrm{rand}(k)$ — D444

Yes

$\hat{X}(k) = -\left(C_{1 \cdot \tau} \overline{X} + | \hat{E}(k) |\right)$ — D446

$\hat{X}(k) = C_{1 \cdot \tau} \overline{X} + \hat{E}(k)$ — D447

$k{++}$ — D448

END STEP D44 (D44')

(2)

(1)

EP 2 573 942 B1

FIG. 18

**①**

k=0   m=0    D4411

k<C₀    D4412    No

Yes    D4413

m<U    No

Yes    D4414

$\hat{E}(k) == 0$    No

Yes    D4415

b(m)==0    No

Yes    D4417

D4416    $\hat{X}(k) = -C_3'\cdot_\tau \overline{\overline{X}}$    $\hat{X}(k) = C_3'\cdot_\tau \overline{\overline{X}}$

m++

D4418

k++    D4419

**②**    UPDATE UNUSED BIT AREA AND SET "U – m" AS NEW U    D4420

50

EP 2 573 942 B1

FIG. 19

START STEP D44'

D4431
k=0    m=0

D442    No
k<C₀

Yes

D443    No
$\hat{E}(k) == 0$

D445    No
$\hat{E}(k) < 0$

Yes

D4438    No
m<U

Yes

D446    Yes

D4439    No
b(m)==0

Yes

D4440
$\hat{X}(k) = -C_3 \cdot_\tau \overline{\overline{X}}$

D4441
$\hat{X}(k) = C_3 \cdot_\tau \overline{\overline{X}}$

D444
$\hat{X}(k) = C_3 \cdot_\tau \overline{\overline{X}} \cdot \text{rand}(k)$

D446
$\hat{X}(k) = -\left(C_1 \cdot_\tau \overline{X} + |\hat{E}(k)|\right)$

D447
$\hat{X}(k) = C_1 \cdot_\tau \overline{X} + \hat{E}(k)$

D4442
m++

k++    D448

END STEP D44'

D4443
UPDATE UNUSED BIT AREA
AND SET "U − m" AS NEW U

EP 2 573 942 B1

# FIG. 20

FIG. 21

EP 2 573 942 B1

③

D4321

$$k = 0$$

D4322

$$k < C_0$$ — No

Yes

D4323

$$\hat{E}(k) == 0$$ — No

Yes

D4324

$$\hat{X}(k) = C_3 \cdot_\tau \overline{\overline{X}} \cdot rand(k)$$

D4328

$$k++$$

END STEPS D43, D44, D44' ◄— ② ◄— ①

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H7261800 B